# EUROPEAN PATENT APPLICATION

(11) **EP 4 290 550 A1**
(43) Date of publication of application: **13.12.2023**
(21) Application number: 22178490.3
(22) Date of filing: 10.06.2022
(51) Int. Cl.: H01J 37/09, H01J 37/02, H01J 37/15, H01J 37/28

(54) **ELECTRON-OPTICAL DEVICE**

(71) Applicant: ASML Netherlands B.V., 5500 AH Veldhoven (NL)
(72) Inventor: OTTEN, Christiaan, 5500 AH Veldhoven (NL); SCHEFFERS, Paul, IJmert, 5500 AH Veldhoven (NL); TEUNISSEN, Christan, 5500 AH Veldhoven (NL); DAAN, Boris, 5500 AH Veldhoven (NL)
(74) Representative: ASML Netherlands B.V.

(57) **Abstract**

A charged particle-optical device for projecting a plurality of charged particle beams along respective beam paths towards a sample location, the charged particle-optical device comprising: a charged particle-optical assembly configured to manipulate the charged particle beams, the charged particle-optical assembly comprising a first charged particle-optical element comprising a plate having one or more apertures around a beam path of the charged particle beams; and an electrical connector configured to electrically connect the plate of the first charged particle-optical element to an electrical power source, wherein the electrical connector: comprises a shield configured to define a field free region substantially free of electric fields; and is configured to be electrically connectable to a flexible coupling configured to electrically connect the plate of the first charged particle-optical element to the electrical power source, the flexible coupling located within the field free region.

## Description

### FIELD

The embodiments provided herein generally relate to a charged particle-optical device, a charged particle-optical assembly, a charged particle-optical apparatus, a method for providing an electrical connection and a method of disconnecting a charged particle-optical assembly from a charged particle-optical device.

### BACKGROUND

When manufacturing semiconductor integrated circuit (IC) chips, undesired pattern defects may occur on a substrate (e.g. wafer) or a mask during the fabrication processes, thereby reducing the yield. Defects may occur as a consequence of, for example, optical effects and incidental particles or other processing step such as etching, deposition of chemical mechanical polishing. Monitoring the extent of the undesired pattern defects is therefore an important process in the manufacture of IC chips. More generally, the inspection and/or measurement of a surface of a substrate, or other object/material, is an important process during and/or after its manufacture.

Pattern inspection tools with a charged particle beam have been used to inspect objects, for example to detect pattern defects. These tools typically use electron microscopy techniques, such as a scanning electron microscope (SEM). In a SEM, a primary electron beam of electrons at a relatively high energy is targeted with a final deceleration step in order to land on a target at a relatively low landing energy. The beam of electrons is focused as a probing spot on the target. The interactions between the material structure at the probing spot and the landing electrons from the beam of electrons cause electrons to be emitted from the surface, such as secondary electrons, backscattered electrons or Auger electrons. The generated secondary electrons may be emitted from the material structure of the target.

By scanning the primary electron beam as the probing spot over the target surface, secondary electrons can be emitted across the surface of the target. By collecting these emitted secondary electrons from the target surface, a pattern inspection tool may obtain an image-like signal representing characteristics of the material structure of the surface of the target. In such inspection the collected secondary electrons are detected by a detector within the tool. The detector generates a signal in response to the incidental particle. As an area of the sample is inspected, the signals comprise data which is processed to generate the inspection image corresponding to the inspected area of the sample. The image may comprise pixels. Each pixel may correspond to a portion of the inspected area. Typically electron beam inspection tool has a single beam and may be referred to as a Single Beam SEM. There have been attempts to introduce a multi-electron beam inspection in a tool (or a 'multi-beam tool') which may be referred to as Multi Beam SEM (MBSEM).

Another application for an electron-optical device (or device or column) is lithography. The charged particle beam reacts with a resist layer on the surface of a substrate. A desired pattern in the resist can be created by controlling the locations on the resist layer that the charged particle beam is directed towards.

An electron-optical device may be an apparatus for generating, illuminating, projecting and/or detecting one or more beams of charged particles. The path of the beam of charged particles is controlled by electromagnetic fields (i.e. electrostatic fields and magnetic fields). Stray electromagnetic fields can undesirably divert the beam.

In some electron-optical devices an electrostatic field is typically generated between two electrodes. There exists a need to apply high voltages to the electrodes. High voltage cables are stiff and a force applied such a high voltage cable connected to such an electrode can undesirably affect the position and/or performance such as formation (e.g. as in deformation) of the electrode to which the cable is connected or even an electrode in a stack of electrodes to which the cable is connected.

### SUMMARY

The present invention provides a suitable architecture to enable the desired high voltage connection with a reduced risk of the connection undesirably affecting the position and/or formation of the connected electrode. According to a first aspect of the invention, there is provided a charged particle-optical device for projecting a plurality of charged particle beams along respective beam paths towards a sample location, the charged particle-optical device comprising: a charged particle-optical assembly configured to manipulate the charged particle beams, the charged particle-optical assembly comprising a first charged particle-optical element comprising a plate having one or more apertures around a beam path of the charged particle beams; and an electrical connector configured to electrically connect the plate of the charged particle-optical element to an electrical power source, wherein the electrical connector: comprises a shield configured to define a field free region substantially free of electric fields; and is configured to be electrically connectable via a flexible coupling configured to electrically connect the plate of the charged particle-optical element to the electrical power source, the flexible coupling located within the field free region.

According to a second aspect of the invention, there is provided a charged particle-optical assembly for operating on one or more charged particle beams in a charged particle apparatus, along a beam path towards a sample location, the charged particle-optical assembly comprising: a charged particle-optical element comprising a plate having one more apertures around a beam path of one or more charged particle beams and configured to manipulate the one or more charged particle beams; and at least one isolator adjacent the plate around the beam path and configured to mechanically support the plate and electrically isolate the plate; and an electrical connector configured to electrically connect the plate to an electrical power source, wherein the electrical connector comprises a protrusion of the plate that extends radially outward of an outward periphery of the isolator or one of the isolators with respect to the beam path, the protrusion configured to be connectable to the electrical power source via a flexible coupling in a field free region substantially free of electric fields.

According to a third aspect of the invention, there is provided a charged particle-optical assembly configured to direct a plurality of beams of charged particles in a beam grid towards a sample, the assembly comprising a charged particle-optical component that comprises: a planar charged particle-optical element configured to operate at high voltage on charged particle beams of a beam grid, the element comprising a plurality of apertures for the paths of different beams of the beam grid; an isolating spacer configured to: support and electrically isolate the charged particle-optical element, and be positioned away from the paths of the beams; and a conductive body structurally connected to a connection surface of the assembly and electrically connected to the charged particle element, wherein a recess is defined within the conductive body and is configured to provide a field free volume for insertion of an electrical coupling to electrically connect the charged particle-optical element via the electrical coupling with the conducting body.

According to a fourth aspect of the invention, there is provided a method for providing an electrical connection, the method comprising: providing a charged particle-optical device configured to project a plurality of charged particle beams along respective beam paths towards a sample location, the charged particle-optical device comprising a charged particle-optical assembly configured to manipulate the charged particle beams, the charged particle-optical assembly comprising a charged particle-optical element comprising a plate having one or more apertures around a beam path of the charged particle beams; and providing an electrical connector configured to electrically connect the plate to an electrical power source, wherein the electrical connector: comprises a shield configured to define a field free region substantially free of electric fields; and is configured to be electrically connectable to a flexible coupling configured to electrically connect the plate to the electrical power source, the flexible coupling located within the field free region.

According to a fourth aspect of the invention, there is provided a method of disconnecting a charged particle-optical assembly from a charged particle-optical device configured to project a plurality of charged particle beams along respective beam paths towards a sample location, the charged particle-optical device comprising a charged particle-optical assembly configured to manipulate the charged particle beams, the charged particle-optical assembly comprising a charged particle-optical element comprising a plate having one or more apertures around a beam path of the charged particle beams, the plate being electrically connected to an electrical power source via a flexible coupling located within a field free region defined by a shield, the method comprising: electrically disconnecting the plate from an electrical power source by disconnecting the flexible coupling from one of the electrical power source and the charged particle-optical assembly with the flexible coupling remaining connected to the other of the charged particle-optical assembly and the electrical power source.

Advantages of the present invention will become apparent from the following description taken in conjunction with the accompanying drawings wherein are set forth, by way of illustration and example, certain embodiments of the present invention.

### BRIEF DESCRIPTION OF FIGURES

The above and other aspects of the present disclosure will become more apparent from the description of exemplary embodiments, taken in conjunction with the accompanying drawings.
Figure 1 is a schematic diagram illustrating an exemplary electron beam inspection apparatus.
Figure 2 is a schematic diagram illustrating an exemplary multi-beam electron-optical device that is part of the exemplary electron beam inspection apparatus of Figure 1.
Figure 3 is a schematic diagram of an exemplary electron-optical device comprising a collimator element array and a scan-deflector array that is part of the exemplary electron beam inspection apparatus of Figure 1.
Figure 4 is a schematic diagram of an exemplary electron-optical device array comprising the electron-optical devices of Figure 3.
Figure 5 is a schematic diagram of an alternative exemplary electron-optical device that is part of the exemplary electron beam inspection apparatus of Figure 1.
Figure 6 is a schematic diagram of an exemplary electron-optical assembly that is part of the electron-optical devices of Figures 3, 4 and 5.
Figure 7 is a schematic diagram of an electrical connector of an exemplary electron-optical assembly.
Figure 8 is a schematic diagram of an electrical connector of an exemplary electron-optical assembly.
Figure 9 is a plan view of an electrical connector of an exemplary electron-optical assembly.
Figure 10 is a cross sectional view of the electrical connector shown in Figure 8.
Figure 11 is a schematic diagram of an electrical connector of an exemplary electron-optical assembly.
Figure 12 is a schematic diagram of an electrical connector of an exemplary electron-optical assembly.
Figure 13 is a schematic diagram of an electrical connector of an exemplary electron-optical assembly.
Figure 14 is a schematic diagram of an electrical connector of an exemplary electron-optical assembly.
Figure 15 is a different view of electrical connectors including the electrical connector shown in Figure 14.
Figure 16 is a schematic diagram of a connection between a shield and a flexible coupling of an electrical connector.
Figure 17 is a schematic diagram of a connection between a shield and a flexible coupling of an electrical connector.
Figure 18 is a schematic diagram of a connection between a shield and a flexible coupling of an electrical connector.

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of apparatuses and methods consistent with aspects related to the invention as recited in the appended claims.

### BRIEF DESCRIPTION OF FIGURES

The reduction of the physical size of devices, and enhancement of the computing power of electronic devices, may be accomplished by significantly increasing the packing density of circuit components such as transistors, capacitors, diodes, etc. on an IC chip. This has been enabled by increased resolution enabling yet smaller structures to be made. Semiconductor IC manufacturing is a complex and time-consuming process, with hundreds of individual steps. An error in any step of the process of manufacturing an IC chip has the potential to adversely affect the functioning of the final product. Just one defect could cause device failure. It is desirable to improve the overall yield of the process. For example, to obtain a 75% yield for a 50-step process (where a step may indicate the number of layers formed on a wafer), each individual step must have a yield greater than 99.4%,. If an individual step has a yield of 95%, the overall process yield would be as low as 7-8%.

Maintaining a high substrate (i.e. wafer) throughput, defined as the number of substrates processed per hour, is also desirable. High process yield and high substrate throughput may be impacted by the presence of a defect. This is especially true if operator intervention is required for reviewing the defects. High throughput detection and identification of micro and nano-scale defects by inspection tools (such as a Scanning Electron Microscope ('SEM')) is desirable for maintaining high yield and low cost for IC chips.

A scanning electron microscope comprises a scanning device and a detector apparatus. The scanning device comprises an illumination apparatus that comprises an electron source, for generating primary electrons, and a projection apparatus for scanning a target, such as a substrate, with one or more focused beams of primary electrons. The primary electrons interact with the target and generate interaction products, such as secondary electrons and/or backscattered electrons. The detection apparatus captures the secondary electrons and/or backscattered electrons from the target as the target is scanned so that the scanning electron microscope may create an image of the scanned area of the target. A design of electron-optical tool embodying these scanning electron microscope features may have a single beam. For higher throughput such as for inspection, some designs of apparatus use multiple focused beams, i.e. a multi-beam, of primary electrons. The component beams of the multi-beam may be referred to as sub-beams or beamlets. A multi-beam may scan different parts of a target simultaneously. A multi-beam inspection apparatus may therefore inspect a target much quicker, e.g. by moving the target at a higher speed, than a single-beam inspection apparatus.

In a multi-beam inspection apparatus, the paths of some of the primary electron beams are displaced away from the central axis, i.e. a mid-point of the primary electron-optical axis (also referred to herein as the charged particle axis), of the scanning device. To ensure all the electron beams arrive at the sample surface with substantially the same angle of incidence, sub-beam paths with a greater radial distance from the central axis need to be manipulated to move through a greater angle than the sub-beam paths with paths closer to the central axis. This stronger manipulation may cause aberrations that cause the resulting image to be blurry and out-of-focus. An example is spherical aberrations which bring the focus of each sub-beam path into a different focal plane. In particular, for sub-beam paths that are not on the central axis, the change in focal plane in the sub-beams is greater with the radial displacement from the central axis. Such aberrations and de-focus effects may remain associated with the secondary electrons from the target when they are detected, for example the shape and size of the spot formed by the sub-beam on the target will be affected. Such aberrations therefore degrade the quality of resulting images that are created during inspection.

An implementation of a known multi-beam inspection apparatus is described below.

The Figures are schematic. Relative dimensions of components in drawings are therefore exaggerated for clarity. Within the following description of drawings the same or like reference numbers refer to the same or like components or entities, and only the differences with respect to the individual embodiments are described. While the description and drawings are directed to an electron-optical apparatus, it is appreciated that the embodiments are not used to limit the present disclosure to specific charged particles. References to electrons, and items referred with reference to electrons, throughout the present document may therefore be more generally be considered to be references to charged particles, and items referred to in reference to charged particles, with the charged particles not necessarily being electrons.

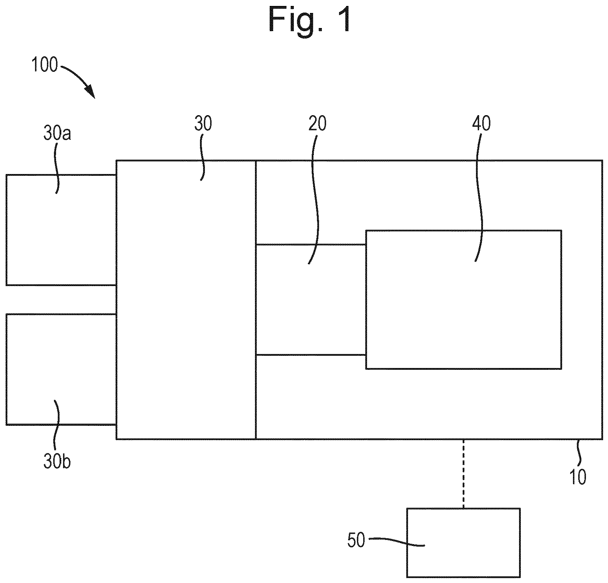

Reference is now made to Figure 1, which is a schematic diagram illustrating an exemplary electron beam assessment apparatus, or inspection apparatus, 100. The inspection apparatus 100 of Fig. 1 includes a vacuum chamber 10, a load lock chamber 20, an electron-optical apparatus, an equipment front end module (EFEM) 30 and a controller 50. The electron-optical device 40 may be within the vacuum chamber 10. The electron-optical apparatus may comprise an electron-optical device 40 (also known as an electron-optical device, an electron beam device or an electron beam device) and a motorized or actuated stage.

The EFEM 30 includes a first loading port 30a and a second loading port 30b. The EFEM 30 may include additional loading port(s). The first loading port 30a and second loading port 30b may, for example, receive substrate front opening unified pods (FOUPs) that contain substrates (e.g., semiconductor substrates or substrates made of other material(s)) or targets to be inspected (substrates, wafers and samples are collectively referred to as "targets" hereafter). One or more robot arms (not shown) in EFEM 30 transport the targets to load lock chamber 20.

The load lock chamber 20 is used to remove the gas around a target. The load lock chamber 20 may be connected to a load lock vacuum pump system (not shown), which removes gas particles in the load lock chamber 20. The operation of the load lock vacuum pump system enables the load lock chamber to reach a first pressure below the atmospheric pressure. The main chamber 10 is connected to a main chamber vacuum pump system (not shown). The main chamber vacuum pump system removes gas molecules in the main chamber 10 so that the pressure around the target reaches a second pressure lower than the first pressure. After reaching the second pressure, the target is transported to the electron-optical device 40 by which it may be inspected. An electron-optical device 40 may comprise either a single beam or a multi-beam electron-optical apparatus.

The controller 50 is electronically connected to the electron-optical device 40. The controller 50 may be a processor (such as a computer) configured to control the charged particle beam inspection apparatus 100. The controller 50 may also include a processing circuitry configured to execute various signal and image processing functions. While the controller 50 is shown in Figure 1 as being outside of the structure that includes the main chamber 10, the load lock chamber 20, and the EFEM 30, it is appreciated that the controller 50 may be part of the structure. The controller 50 may be located in one of the component elements of the charged particle beam inspection apparatus or it may be distributed over at least two of the component elements. While the present disclosure provides examples of main chamber 10 housing an electron beam inspection tool, it should be noted that aspects of the disclosure in their broadest sense are not limited to a chamber housing an electron-optical device. Rather, it is appreciated that the foregoing principles may also be applied to other tools and other arrangements of apparatus that operate under the second pressure.

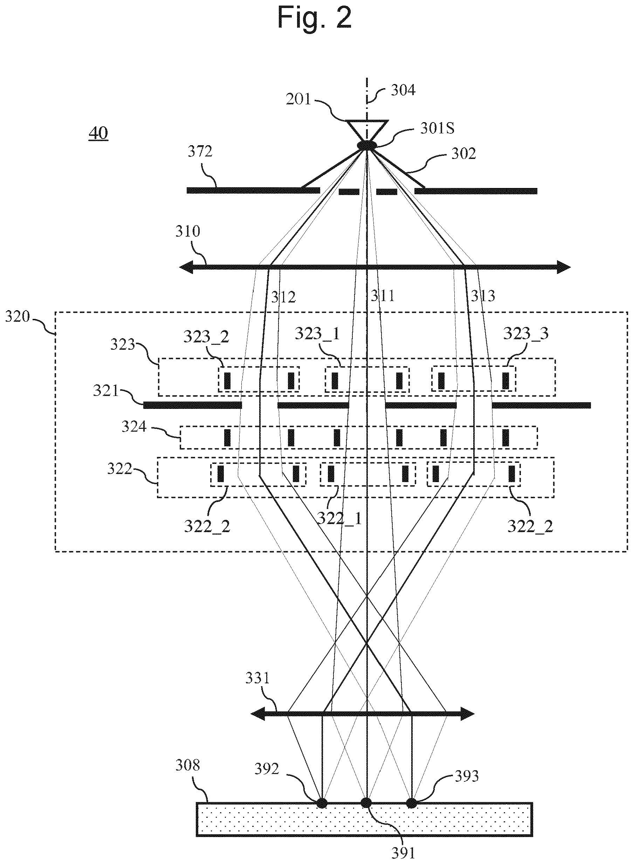

Reference is now made to Figure 2, which is a schematic diagram of an exemplary multi-beam electron-optical device 40 of the inspection apparatus 100 of Figure 1. In an alternative embodiment the inspection apparatus 100 is a single-beam inspection apparatus. The electron-optical device 40 may comprise an electron source 201, a beam former array 372 (also known as a gun aperture plate, a coulomb aperture array or a pre-sub-beam-forming aperture array), a condenser lens 310, a source converter (or micro-optical array) 320, an objective lens 331, and a target 308. In an embodiment the condenser lens 310 is magnetic. The target 308 may be supported by a support on a stage. The stage may be motorized. The stage moves so that the target 308 is scanned by the incidental electrons. The electron source 201, the beam former array 372, the condenser lens 310 may be the components of an illumination apparatus comprised by the electron-optical device 40. The source converter 320 (also known as a source conversion unit), described in more detail below, and the objective lens 331 may be the components of a projection apparatus comprised by the electron-optical device 40.

The electron source 201, the beam former array 372, the condenser lens 310, the source converter 320, and the objective lens 331 are aligned with a primary electron-optical axis 304 of the electron-optical device 40. The electron source 201 may generate a primary beam 302 generally along the electron-optical axis 304 and with a source crossover (virtual or real) 301S. During operation, the electron source 201 is configured to emit electrons. The electrons are extracted or accelerated by an extractor and/or an anode to form the primary beam 302.

The beam former array 372 cuts the peripheral electrons of primary electron beam 302 to reduce a consequential Coulomb effect. The primary-electron beam 302 may be trimmed into a specified number of sub-beams, such as three sub-beams 311, 312 and 313, by the beam former array 372. It should be understood that the description is intended to apply to an electron-optical device 40 with any number of sub-beams such as one, two or more than three. The beam former array 372, in operation, is configured to block off peripheral electrons to reduce the Coulomb effect. The Coulomb effect may enlarge the size of each of the probe spots 391, 392, 393 and therefore deteriorate inspection resolution. The beam former array 372 reduces aberrations resulting from Coulomb interactions between electrons projected in the beam. The beam former array 372 may include multiple openings for generating primary sub-beams even before the source converter 320.

The source converter 320 is configured to convert the beam (including sub-beams if present) transmitted by the beam former array 372 into the sub-beams that are projected towards the target 308. In an embodiment the source converter is a unit. Alternatively, the term source converter may be used simply as a collective term for the group of components that form the beamlets from the sub-beams.

As shown in Figure 2, in an embodiment the electron-optical device 40 comprises a beam-limiting aperture array 321 with an aperture pattern (i.e. apertures arranged in a formation) configured to define the outer dimensions of the beamlets (or sub-beams) projected towards the target 308. In an embodiment the beam-limiting aperture array 321 is part of the source converter 320. In an alternative embodiment the beam-limiting aperture array 321 is part of the system up-beam of the main device. In an embodiment, the beam-limiting aperture array 321 divides one or more of the sub-beams 311, 312, 313 into beamlets such that the number of beamlets projected towards the target 308 is greater than the number of sub-beams transmitted through the beam former array 372. In an alternative embodiment, the beam-limiting aperture array 321 keeps the number of the sub-beams incident on the beam-limiting aperture array 321, in which case the number of sub-beams may equal the number of beamlets projected towards the target 308.

As shown in Figure 2, in an embodiment the electron-optical device 40 comprises a pre-bending deflector array 323 with pre-bending deflectors 323_1, 323_2, and 323_3 to bend the sub-beams 311, 312, and 313 respectively. The pre-bending deflectors 323_1, 323_2, and 323_3 may bend the path of the sub-beams 311, 312, and 313 onto the beam-limiting aperture array 321.

The electron-optical device 40 may also include an image-forming element array 322 with image-forming deflectors 322_1, 322_2, and 322_3. There is a respective deflector 322_1, 322_2, and 322_3 associated with the path of each beamlet. The deflectors 322_1, 322_2, and 322_3 are configured to deflect the paths of the beamlets towards the electron-optical axis 304. The deflected beamlets form virtual images (not shown) of source crossover 301S. In the current embodiment, these virtual images are projected onto the target 308 by the objective lens 331 and form probe spots 391, 392, 393 thereon. The electron-optical device 40 may also include an aberration compensator array 324 configured to compensate aberrations that may be present in each of the sub-beams. In an embodiment the aberration compensator array 324 comprises a lens configured to operate on a respective beamlet. The lens may take the form or an array of lenses. The lenses in the array may operate on a different beamlet of the multi-beam. The aberration compensator array 324 may, for example, include a field curvature compensator array (not shown) for example with micro-lenses. The field curvature compensator and micro-lenses may, for example, be configured to compensate the individual sub-beams for field curvature aberrations evident in the probe spots, 391, 392, and 393. The aberration compensator array 324 may include an astigmatism compensator array (not shown) with micro-stigmators. The micro-stigmators may, for example, be controlled to operate on the sub-beams to compensate astigmatism aberrations that are otherwise present in the probe spots, 391, 392, and 393.

The source converter 320 may further comprise a pre-bending deflector array 323 with pre-bending deflectors 323_1, 323_2, and 323_3 to bend the sub-beams 311, 312, and 313 respectively. The pre-bending deflectors 323_1, 323_2, and 323_3 may bend the path of the sub-beams onto the beam-limiting aperture array 321. In an embodiment, the pre-bending micro-deflector array 323 may be configured to bend the sub-beam path of sub-beams towards the orthogonal of the plane of on beam-limiting aperture array 321. In an alternative embodiment the condenser lens 310 may adjust the path direction of the sub-beams onto the beam-limiting aperture array 321. The condenser lens 310 may, for example, focus (collimate) the three sub-beams 311, 312, and 313 to become substantially parallel beams along primary electron-optical axis 304, so that the three sub-beams 311, 312, and 313 incident substantially perpendicularly onto source converter 320, which may correspond to the beam-limiting aperture array 321. In such alternative embodiment the pre-bending deflector array 323 may not be necessary.

The image-forming element array 322, the aberration compensator array 324, and the pre-bending deflector array 323 may comprise multiple layers of sub-beam manipulating devices, some of which may be in the form or arrays, for example: micro-deflectors, micro-lenses, or micro-stigmators. Beam paths may be manipulated rotationally. Rotational corrections may be applied by a magnetic lens. Rotational corrections may additionally, or alternatively, be achieved by an existing magnetic lens such as the condenser lens arrangement.

In the current example of the electron-optical device 40, the beamlets are respectively deflected by the deflectors 322_1, 322_2, and 322_3 of the image-forming element array 322 towards the electron-optical axis 304. It should be understood that the beamlet path may already correspond to the electron-optical axis 304 prior to reaching deflector 322_1, 322_2, and 322_3.

The objective lens 331 focuses the beamlets onto the surface of the target 308, i.e., it projects the three virtual images onto the target surface. The three images formed by three sub-beams 311 to 313 on the target surface form three probe spots 391, 392 and 393 thereon. In an embodiment the deflection angles of sub-beams 311 to 313 are adjusted to pass through or approach the front focal point of objective lens 331 to reduce or limit the off-axis aberrations of three probe spots 391 to 393. In an arrangement the objective lens 331 is magnetic. Although three beamlets are mentioned, this is by way of example only. There may be any number of beamlets.

A manipulator is configured to manipulate one or more beams of charged particles. The term manipulator encompasses a deflector, a lens and an aperture. The pre-bending deflector array 323, the aberration compensator array 324 and the image-forming element array 322 may individually or in combination with each other, be referred to as a manipulator array, because they manipulate one or more sub-beams or beamlets of charged particles. The lens and the deflectors 322_1, 322_2, and 322_3 may be referred to as manipulators because they manipulate one or more sub-beams or beamlets of charged particles.

In an embodiment a beam separator (not shown) is provided. The beam separator may be down-beam of the source converter 320. The beam separator may be, for example, a Wien filter comprising an electrostatic dipole field and a magnetic dipole field. The beam separator may be positioned between adjacent sections of shielding (described in more detail below) in the direction of the beam path. The inner surface of the shielding may be radially inward of the beam separator. Alternatively, the beam separator may be within the shielding. In operation, the beam separator may be configured to exert an electrostatic force by electrostatic dipole field on individual electrons of sub-beams. In an embodiment, the electrostatic force is equal in magnitude but opposite in direction to the magnetic force exerted by the magnetic dipole field of beam separator on the individual primary electrons of the sub-beams. The sub-beams may therefore pass at least substantially straight through the beam separator with at least substantially zero deflection angles. The direction of the magnetic force depends on the direction of motion of the electrons while the direction of the electrostatic force does not depend on the direction of motion of the electrons. So because the secondary electrons and backscattered electrons generally move in an opposite direction compared to the primary electrons, the magnetic force exerted on the secondary electrons and backscattered electrons will no longer cancel the electrostatic force and as a result the secondary electrons and backscattered electrons moving through the beam separator will be deflected away from the electron-optical axis 304.

In an embodiment a secondary device (not shown) is provided comprising detection elements for detecting corresponding secondary charged particle beams. On incidence of secondary beams with the detection elements, the elements may generate corresponding intensity signal outputs. The outputs may be directed to an image processing system (e.g., controller 50). Each detection element may comprise an array which may be in the form of a grid. The array may have one or more pixels; each pixel may correspond to an element of the array. The intensity signal output of a detection element may be a sum of signals generated by all the pixels within the detection element.

In an embodiment a secondary projection apparatus and its associated electron detection device (not shown) are provided. The secondary projection apparatus and its associated electron detection device may be aligned with a secondary electron-optical axis of the secondary device. In an embodiment the beam separator is arranged to deflect the path of the secondary electron beams towards the secondary projection apparatus. The secondary projection apparatus subsequently focuses the path of secondary electron beams onto a plurality of detection regions of the electron detection device. The secondary projection apparatus and its associated electron detection device may register and generate an image of the target 308 using the secondary electrons or backscattered electrons.

In an embodiment the inspection apparatus 100 comprises a single source.

Any element or collection of elements may be replaceable or field replaceable within the electron-optical device. The one or more electron-optical components in the electron-optical device, especially those that operate on sub-beams or generate sub-beams, such as aperture arrays and manipulator arrays may comprise one or more microelectromechanical systems (MEMS). The pre-bending deflector array 323 may be a MEMS. MEMS are miniaturized mechanical and electromechanical elements that are made using microfabrication techniques. In an embodiment the electron-optical device 40 comprises apertures, lenses and deflectors formed as MEMS. In an embodiment, the manipulators such as the lenses and deflectors 322_1, 322_2, and 322_3 are controllable, passively, actively, as a whole array, individually or in groups within an array, so as to control the beamlets of charged particles projected towards the target 308.

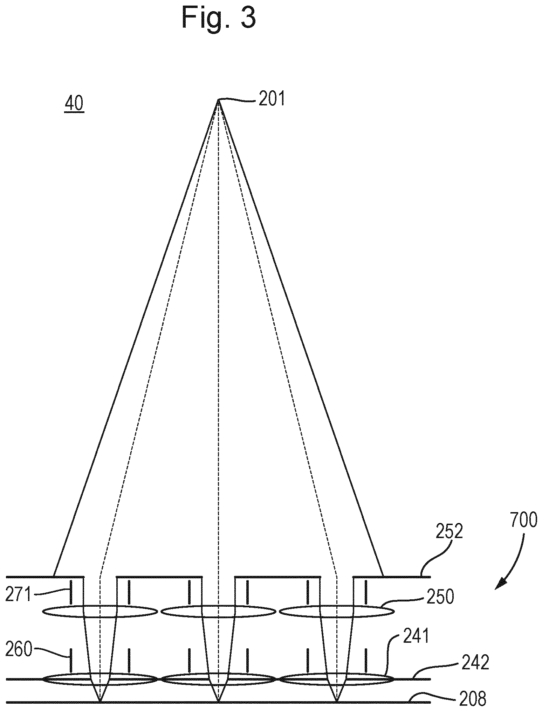

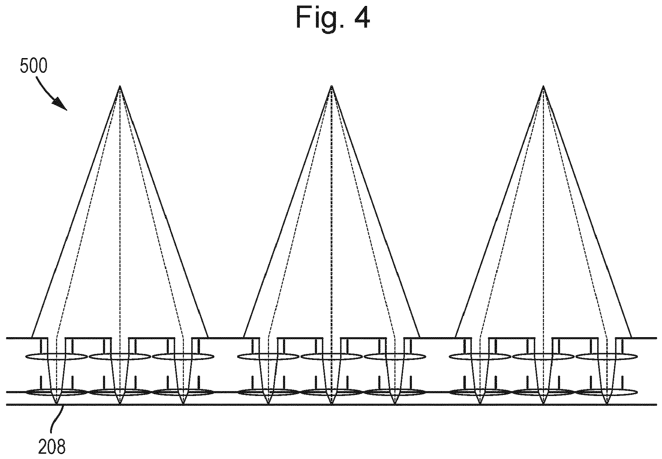

In an embodiment the electron-optical device 40 may comprise alternative and/or additional components on the charged particle path, such as lenses and other components some of which have been described earlier with reference to Figures. 1 and 2. Examples of such arrangements are shown in Figures 3 and 4 which are described in further detail later. In particular, embodiments include an electron-optical device 40 that divides a charged particle beam from a source into a plurality of sub-beams. A plurality of respective objective lenses may project the sub-beams onto a sample. In some embodiments, a plurality of condenser lenses is provided up-beam from the objective lenses. The condenser lenses focus each of the sub-beams to an intermediate focus up-beam of the objective lenses. In some embodiments, collimators are provided up-beam from the objective lenses. Correctors may be provided to reduce focus error and/or aberrations. In some embodiments, such correctors are integrated into or positioned directly adjacent to the objective lenses. Where condenser lenses are provided, such correctors may additionally, or alternatively, be integrated into, or positioned directly adjacent to, the condenser lenses and/or positioned in, or directly adjacent to, the intermediate foci. A detector is provided to detect charged particles emitted by the sample. The detector may be integrated into the objective lens. The detector may be on the bottom surface of the objective lens so as to face a sample in use. The detector may comprise an array which may correspond to the array of the beamlets of the multi-beam arrangement. The detectors in the detector array may generate detection signals that may be associated with the pixels of a generated image. The condenser lenses, objective lenses and/or detector may be formed as MEMS or CMOS devices.

Figure 3 is a schematic diagram of another design of an exemplary electron-optical device 40. The electron-optical device 40 may comprise a source 201 and one or more electron-optical assemblies. Alternatively, the electron-optical apparatus that comprises the electron-optical device 40 may comprise the source 201. The electron-optical device 40 may comprise an upper beam limiter 252, a collimator element array 271, a control lens array 250, a scan deflector array 260, an objective lens array 241, a beam shaping limiter 242 and a detector array. The source 201 provides a beam of charged particles (e.g. electrons). The multi-beam focused on the sample 208 is derived from the beam provided by the source 201. Sub-beams may be derived from the beam, for example, using a beam limiter defining an array of beam-limiting apertures. The source 201 is desirably a high brightness thermal field emitter with a good compromise between brightness and total emission current.

The upper beam limiter 252 defines an array of beam-limiting apertures. The upper beam limiter 252 may be referred to as an upper beam-limiting aperture array or up-beam beam-limiting aperture array. The upper beam limiter 252 may comprise a plate (which may be a plate-like body) having a plurality of apertures. The upper beam limiter 252 forms the sub-beams from the beam of charged particles emitted by the source 201. Portions of the beam other than those contributing to forming the sub-beams may be blocked (e.g. absorbed) by the upper beam limiter 252 so as not to interfere with the sub-beams down-beam. The upper beam limiter 252 may be referred to as a sub-beam defining aperture array.

The collimator element array 271 is provided down-beam of the upper beam limiter. Each collimator element collimates a respective sub-beam. The collimator element array 271 may be formed using MEMS manufacturing techniques so as to be spatially compact. In some embodiments, exemplified in Figure 3, the collimator element array 271 is the first deflecting or focusing electron-optical array element in the beam path down-beam of the source 201. In another arrangement, the collimator may take the form, wholly or partially, of a macro-collimator. Such a macro-collimator may be up beam of the upper beam limiter 252 so it operates on the beam from the source before generation of the multi-beam. A magnetic lens may be used as the macro-collimator.

Down-beam of the collimator element array there is the control lens array 250. The control lens array 250 comprises a plurality of control lenses. Each control lens comprises at least two electrodes (e.g. two or three electrodes) connected to respective potential sources. The control lens array 250 may comprise two or more (e.g. three) plate electrode arrays connected to respective potential sources. The control lens array 250 is associated with the objective lens array 241 (e.g. the two arrays are positioned close to each other and/or mechanically connected to each other and/or controlled together as a unit). The control lens array 250 is positioned up-beam of the objective lens array 241. The control lenses pre-focus the sub-beams (e.g. apply a focusing action to the sub-beams prior to the sub-beams reaching the objective lens array 241). The pre-focusing may reduce divergence of the sub-beams or increase a rate of convergence of the sub-beams.

As mentioned, the control lens array 250 is associated with the objective lens array 241. As described above, the control lens array 250 may be considered as providing electrodes additional to the electrodes 242, 243 of the objective lens array 241 for example as part of an objective lens array assembly. The additional electrodes of the control lens array 250 allow further degrees of freedom for controlling the electron-optical parameters of the sub-beams. In an embodiment the control lens array 250 may be considered to be additional electrodes of the objective lens array 241 enabling additional functionality of the respective objective lenses of the objective lens array 241. In an arrangement such electrodes may be considered part of the objective lens array providing additional functionality to the objective lenses of the objective lens array 241. In such an arrangement, the control lens is considered to be part of the corresponding objective lens, even to the extent that the control lens is only referred to as being a part of the objective lens for example in terms of providing one more extra degrees of freedom to the objective lens.

For ease of illustration, lens arrays are depicted schematically herein by arrays of oval shapes. Each oval shape represents one of the lenses in the lens array. The oval shape is used by convention to represent a lens, by analogy to the biconvex form often adopted in optical lenses. In the context of charged-particle arrangements such as those discussed herein, it will be understood however that lens arrays will typically operate electrostatically and so may not require any physical elements adopting a biconvex shape. As described above, lens arrays may instead comprise multiple plates with apertures.

The scan-deflector array 260 comprising a plurality of scan deflectors may be provided. The scan-deflector array 260 may be formed using MEMS manufacturing techniques. Each scan deflector scans a respective sub-beam over the sample 208. The scan-deflector array 260 may thus comprise a scan deflector for each sub-beam. Each scan deflector may deflect the sub-beam in one direction (e.g. parallel to a single axis, such as an X axis) or in two directions (e.g. relative to two non-parallel axes, such as X and Y axes). The deflection is such as to cause the sub-beam to be scanned across the sample 208 in the one or two directions (i.e. one dimensionally or two dimensionally). In an embodiment, the scanning deflectors described in EP2425444, which document is hereby incorporated by reference in its entirety specifically in relation to scan deflectors, may be used to implement the scan-deflector array 260. A scan-deflector array 260 (e.g. formed using MEMS manufacturing techniques as mentioned above) may be more spatially compact than a macro scan deflector. In another arrangement, a macro scan deflector may be used up beam of the upper beam limiter 252. Its function may be similar or equivalent to the scan-deflector array although it operates on the beam from the source before the beamlets of the multi-beam are generated.

The objective lens array 241 comprising a plurality of objective lenses is provided to direct the sub-beams onto the sample 208. Each objective lens comprises at least two electrodes (e.g. two or three electrodes) connected to respective potential sources. The objective lens array 241 may comprise two or more (e.g. three) plate electrode arrays connected to respective potential sources. Each objective lens formed by the plate electrode arrays may be a micro-lens operating on a different sub-beam. Each plate defines a plurality of apertures (which may also be referred to as holes). The position of each aperture in a plate corresponds to the position of a corresponding aperture (or apertures) in the other plate (or plates). The corresponding apertures define the objective lenses and each set of corresponding apertures therefore operates in use on the same sub-beam in the multi-beam. Each objective lens projects a respective sub-beam of the multi-beam onto a sample 208.

An objective lens array 241 having only two electrodes can have lower aberration than an objective lens array 241 having more electrodes. A three-electrode objective lens can have greater potential differences between the electrodes and so enable a stronger lens. Additional electrodes (i.e. more than two electrodes) provide additional degrees of freedom for controlling the electron trajectories, e.g. to focus secondary electrons as well as the incident beam. Such additional electrodes may be considered to form the control lens array 250. A benefit of a two electrode lens over an Einzel lens is that the energy of an incoming beam is not necessarily the same as an outgoing beam. Beneficially the potential differences on such a two electrode lens array enables it to function as either an accelerating or a decelerating lens array.

The objective lens array may form part of an objective lens array assembly along with any or all of the scan-deflector array 260, control lens array 250 and collimator element array 271. The objective lens array assembly may further comprise the beam shaping limiter 242. The beam shaping limiter 242 defines an array of beam-limiting apertures. The beam shaping limiter 242 may be referred to as a lower beam limiter, lower beam-limiting aperture array or final beam-limiting aperture array. The beam shaping limiter 242 may comprise a plate (which may be a plate-like body) having a plurality of apertures. The beam shaping limiter 242 is down-beam from at least one electrode (optionally from all electrodes) of the control lens array 250. In some embodiments, the beam shaping limiter 242 is down-beam from at least one electrode (optionally from all electrodes) of the objective lens array 241.

In an arrangement, the beam shaping limiter 242 is structurally integrated with an electrode 302 of the objective lens array 241. Desirably, the beam shaping limiter 242 is positioned in a region of low electrostatic field strength. Each of the beam-limiting apertures is aligned with a corresponding objective lens in the objective lens array 241. The alignment is such that a portion of a sub-beam from the corresponding objective lens can pass through the beam-limiting aperture and impinge onto the sample 208. Each beam-limiting aperture has a beam limiting effect, allowing only a selected portion of the sub-beam incident onto the beam shaping limiter 242 to pass through the beam-limiting aperture. The selected portion may be such that only a portion of the respective sub-beam passing through a central portion of respective apertures in the objective lens array reaches the sample. The central portion may have a circular cross-section and/or be centered on a beam axis of the sub-beam.

In an embodiment, the electron-optical device 40 is configured to control the objective lens array assembly (e.g. by controlling potentials applied to electrodes of the control lens array 250) so that a focal length of the control lenses is larger than a separation between the control lens array 250 and the objective lens array 241. The control lens array 250 and objective lens array 241 may thus be positioned relatively close together, with a focusing action from the control lens array 250 that is too weak to form an intermediate focus between the control lens array 250 and objective lens array 241. The control lens array and the objective lens array operate together to for a combined focal length to the same surface. Combined operation without an intermediate focus may reduce the risk of aberrations. In other embodiments, the objective lens array assembly may be configured to form an intermediate focus between the control lens array 250 and the objective lens array 241.

An electric power source may be provided to apply respective potentials to electrodes of the control lenses of the control lens array 250 and the objective lenses of the objective lens array 241.

The provision of a control lens array 250 in addition to an objective lens array 241 provides additional degrees of freedom for controlling properties of the sub-beams. The additional freedom is provided even when the control lens array 250 and objective lens array 241 are provided relatively close together, for example such that no intermediate focus is formed between the control lens array 250 and the objective lens array 241. The control lens array 250 may be used to optimize a beam opening angle with respect to the demagnification of the beam and/or to control the beam energy delivered to the objective lens array 241. The control lens may comprise two or three or more electrodes. If there are two electrodes then the demagnification and landing energy are controlled together. If there are three or more electrodes the demagnification and landing energy can be controlled independently. The control lenses may thus be configured to adjust the demagnification and/or beam opening angle and/or the landing energy on the substrate of respective sub-beams (e.g. using the electric power source to apply suitable respective potentials to the electrodes of the control lenses and the objective lenses). This optimization can be achieved without having an excessively negative impact on the number of objective lenses and without excessively deteriorating aberrations of the objective lenses (e.g. without decreasing the strength of the objective lenses). Use of the control lens array enables the objective lens array to operate at its optimal electric field strength. Note that it is intended that the reference to demagnification and opening angle is intended to refer to variation of the same parameter. In an ideal arrangement the product of a range of demagnification and the corresponding opening angles is constant. However, the opening angle may be influenced by the use of an aperture.

In an embodiment, the landing energy can be controlled to a desired value in a predetermined range, e.g. from 1000 eV to 5000 eV. Desirably, the landing energy is primarily varied by controlling the energy of the electrons exiting the control lens. The potential differences within the objective lenses are preferably kept constant during this variation so that the electric field within the objective lens remains as high as possible. The potentials applied to the control lens in addition may be used to optimize the beam opening angle and demagnification. The control lens can function to change the demagnification in view of changes in landing energy. Desirably, each control lens comprises three electrodes so as to provide two independent control variables. For example, one of the electrodes can be used to control magnification while a different electrode can be used to independently control landing energy. Alternatively each control lens may have only two electrodes. When there are only two electrodes, one of the electrodes may need to control both magnification and landing energy.

The detector array (not shown) is provided to detect charged particles emitted from the sample 208. The detected charged particles may include any of the charged particles detected by a scanning electron microscope, including secondary and/or backscattered electrons emitted from the sample 208. The detector may be an array providing the surface of the electron-optical device facing the sample 208, e.g. the bottom surface of the electron-optical device. Alternative the detector array be up beam of the bottom surface or example in or up beam of the objective lens array or the control lens array. The elements of the detector array may correspond to the beamlets of the multi-beam arrangement. The signal generated by detection of an electron by an element of the array be transmitted to a processor for generation of an image. The signal may correspond to a pixel of an image.

In other embodiments both a macro scan deflector and the scan-deflector array 260 are provided. In such an arrangement, the scanning of the sub-beams over the sample surface may be achieved by controlling the macro scan deflector and the scan-deflector array 260 together, preferably in synchronization.

In an embodiment, as exemplified in Figure 4, an electron-optical device array 500 is provided. The array 500 may comprise a plurality of any of the electron-optical devices described herein. Each of the electron-optical devices focuses respective multi-beams simultaneously onto different regions of the same sample. Each electron-optical device may form sub-beams from a beam of charged particles from a different respective source 201. Each respective source 201 may be one source in a plurality of sources 201. At least a subset of the plurality of sources 201 may be provided as a source array. The source array may comprise a plurality of sources 201 provided on a common substrate. The focusing of plural multi-beams simultaneously onto different regions of the same sample allows an increased area of the sample 208 to be processed (e.g. assessed) simultaneously. The electron-optical devices in the array 500 may be arranged adjacent to each other so as to project the respective multi-beams onto adjacent regions of the sample 208.

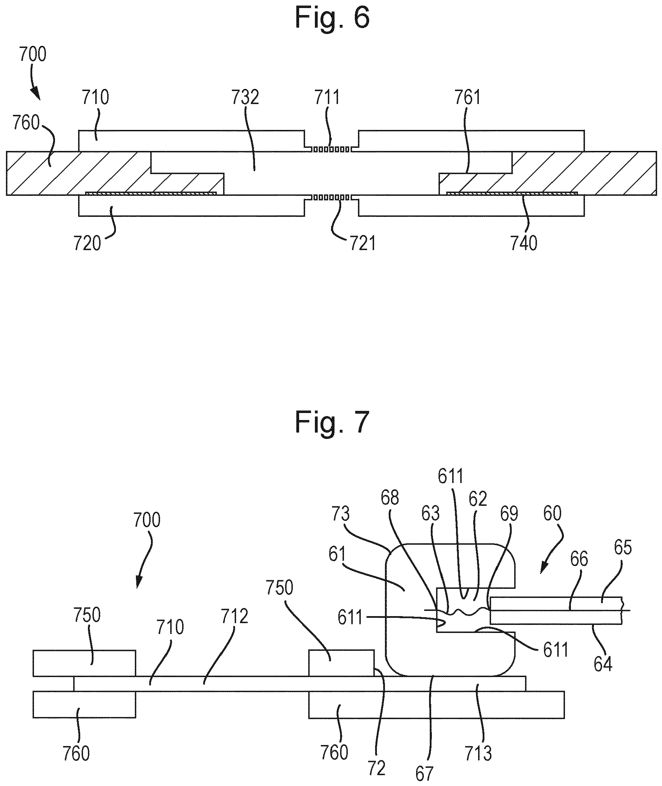

Any number of electron-optical devices may be used in the array 500. Preferably, the number of electron-optical devices is in the range of from two (2), desirably nine (9) to one hundred (100) even two hundred (200). In an embodiment, the electron-optical devices are arranged in a rectangular array or in a hexagonal array. In other embodiments, the electron-optical devices are provided in an irregular array or in a regular array having a geometry other than rectangular or hexagonal. Each electron-optical device in the array 500 may be configured in any of the ways described herein when referring to a single electron-optical device, for example as described above, especially with respect to the embodiment shown and described in reference to Fig 6. Details of such an arrangement is described in EPA 20184161.6 filed 6 July 2020 which, with respect to how the objective lens is incorporated and adapted for use in the multi-device arrangement is hereby incorporated by reference.

In the example of Figure 4 the array 500 comprises a plurality of electron-optical devices of the type described above with reference to Figure 3. Each of the electron-optical devices in this example thus comprise both a scan-deflector array 260 and a collimator element array 271. As mentioned above, the scan-deflector array 260 and collimator element array 271 are particularly well suited to incorporation into an electron-optical device array 500 because of their spatial compactness, which facilitates positioning of the electron-optical devices close to each other. This arrangement of electron-optical device may be preferred over other arrangements that use a magnetic lens as collimator. Magnetic lenses may be challenging to incorporate into an electron-optical device intended for use in a multi-device arrangement (e.g. multi-column arrangement) for example because of magnetic interference between columns.

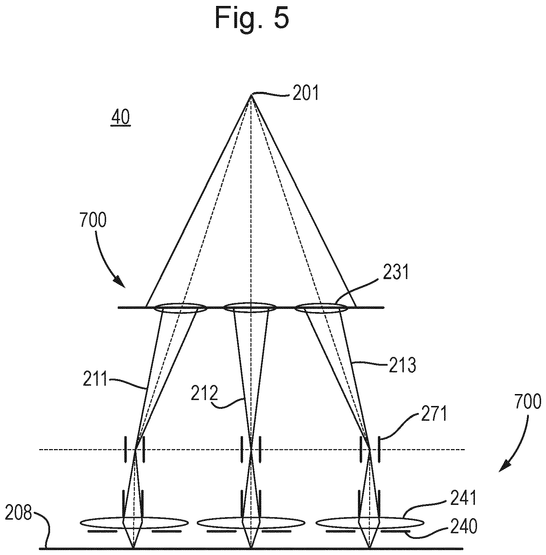

An alternative design of multi-beam electron-optical device may have the same features as described with respect to Figure 3 expect as described below and illustrated in Figure 5. The alternative design of multi-beam electron-optical device may comprise a condenser lens array 231 upbeam of the object lens array arrangement 241, as disclosed in EP application 20158804.3 filed on 21 February 2020 which is hereby incorporated by reference so far as the description of the multi-beam device with a collimator and its components. Such a design does not require the beam shaping limiter array 242 or the upper beam limiter array 252 because a beam limiting aperture array associated with condenser lens array 231 may shape the beamlets 211, 212, 213 of the multi-beam from the beam of the source 201. The beam limiting aperture array of the condenser lens may also function as an electrode in the lens array.

The paths of the beamlets 211, 212, 213 diverge away from the condenser lens array 231. The condenser lens array 231 focuses the generated beamlets to an intermediate focus between the condenser lens array 231 and the objective lens array assembly 241 (i.e. towards the control lens array and the objective lens array). The collimator array 271 may be at the intermediate foci instead of associated with the objective lens array assembly 241.

The collimator may reduce the divergence of the diverging beamlet paths. The collimator may collimate the diverging beamlet paths so that they are substantially parallel towards the objective lens array assembly. Corrector arrays may be present in the multi-beam path, for example associated with the condenser lens array, the intermediate foci and the objective lens array assembly. The detector 240 may be integrated into the objective lens 241. The detector 240 may be on the bottom surface of the objective lens 241 so as to face a sample in use.

In an embodiment the detector may be integrated into the electron-optical assembly 700. In an embodiment a detector 240 is associated with, or even integrated into, a plate 710, 720 of the electron-optical assembly 700. For example, the detector 240 may be on the bottom surface of an electron-optical assembly 700 comprising objective lenses 241. The detector 240 may be provided with an electric connection 60 as described elsewhere in this document.

An electron-optical device array may have multiple multi-beam devices of this design as described with reference to the multi-beam device of Figure 3 as shown in Figure 4. Such an arrangement is shown and described in EP Application 20158732.6 filed on 21 February 2020 which is hereby incorporated by reference with respect to the multi-device arrangement of a multi-beam tool featuring the design of multi-beam device disclosed with a collimator at an intermediate focus.

A further alternative design of multi-beam tool comprises multiple single beam devices. The single beams generated for the purposes of the invention herein described may be similar or equivalent to a multi-beam generated by a single device. Such a multi-device tool may have one hundred devices each generating a single beam or beamlet. In this further alternative design the single beam devices may have a common vacuum system, each device have a separate vacuum system or groups of devices are assigned different vacuum systems. Each device may have an associated detector.

The electron-optical device 40 may be a component of an inspection (or metro-inspection) tool or part of an e-beam lithography tool. The multi-beam charged particle apparatus may be used in a number of different applications that include electron microscopy in general, not just scanning electron microscopy, and lithography.

The electron-optical axis 304 describes the path of charged particles through and output from the source 201. The sub-beams and beamlets of a multi-beam may all be substantially parallel to the electron-optical axis 304 at least through the manipulators or electron -optical arrays, unless explicitly mentioned. The electron-optical axis 304 may be the same as, or different from, a mechanical axis of the electron-optical device 40.

The electron-optical device 40 may comprise an electron-optical assembly 700 as shown in Figure 6 for manipulating electron beamlets. For example, the objective lens array 241, and/or the condenser lens array 231 may comprise the electron-optical assembly 700. In particular, the objective lens 331 and/or the condenser lens 310 and/or the control lens 250 may comprise the electron-optical assembly 700.

The electron-optical assembly is configured to provide a potential difference between two or more plates (or substrates). An electrostatic field is generated between the plates, which act as electrodes. The electrostatic field results in an attraction force between the two plates. The attraction force may be increased with increasing potential difference.

In the electron-optical assembly, at least one of the plates has a thickness which is stepped such that the array plate is thinner in the region corresponding to the array of apertures than another region of the array plate. It is advantageous to have a stepped thickness, for example with two portions of the plate having different thicknesses, because at high potential differences the plate is subjected to higher electrostatic forces which can result in bending if the plate were a consistent thickness and, for example, too thin. Bending of the plate can adversely affect beam-to-beam uniformity. Thus, a thick plate is advantageous to mitigate bending. However, if the plate is too thick in the region of the array of apertures, it can result in undesirable electron beamlet deformation. Thus, a thin plate around the array of apertures is advantageous to mitigate electron beamlet deformation. That is in a region of the plate thinner than the rest of the plate the array of apertures may be defined. The stepped thickness of the plate thus reduces the likelihood of bending, without increasing the likelihood of beamlet deformation.

The exemplary electron-optical assembly shown in Figure 6 comprises an array plate 710, an adjoining plate 720 and an isolator (or spacer) 730. (Note the term 'array plate' is a term used to different the plate from other plates referred to in the description). In the array plate, an array of apertures 711 is defined for the path of electron beamlets. The number of apertures in the array of apertures may correspond to the number of sub-beams in the multi-beam arrangement. In one arrangement there are fewer apertures than sub-beams in the multi-beam so that groups of sub-beam paths pass through an aperture. For example an aperture may extend across the multi-beam path; the aperture may be a strip or slit. The isolator 730 is disposed between the plates to separate the plates. The electron-optical assembly is configured to provide a potential difference between the array plate 710 and the adjoining plate 720.

In the adjoining plate 720, another array of apertures 721 is defined for the path of the electron beamlets. The adjoining plate 720 may also have a thickness which is stepped such that the adjoining plate is thinner in the region corresponding to the array of apertures than another region of the adjoining plate. Preferably, the array of apertures 721 defined in the adjoining plate 720 has the same pattern as the array of apertures 711 defined in the array plate 710. In an arrangement the pattern of the array of apertures in the two plates may be different. For example, the number of apertures in the adjoining plate 720 may be fewer or greater than the number of apertures in the array plate 710. In an arrangement there is a single aperture in the adjoining plate for all the paths of the sub-beams of the multi-beam. Preferably the apertures in the array plate 710 and the adjoining plate 720, are substantially mutually well aligned. This alignment between the apertures is in order to limit lens aberrations

The array plate and the adjoining plate may each have a thickness of up to 1.5 mm at the thickest point of the plate, preferably 1 mm, more preferably 500 µm. In an arrangement, the downbeam plate (i.e., the plate closer to the sample) may have a thickness of between 200 µm and 300 µm at its thickest point. The downbeam plate preferably a thickness of between 200 µm and 150 µm at its thickest point. The upbeam plate (i.e., the plate farther from the sample) may have a thickness of up to 500 µm at its thickest point.

A surface of the array plate between the thinner region of the plate 710 and the other region, e.g. the thicker region, of the plate, for example that provides the step is preferably orthogonal to the surface of the plate facing the adjoining plate 720 and/or the path of the multi-beam. Similarly, a surface of the adjoining plate 720 at the step between the thicker region (radially outward) and the inner region (radially inward) may preferably be orthogonal to the surface of the adjoining plate facing the array plate 710.

A coating may be provided on a surface of the array plate and/or the adjoining plate. Preferably both the coating is provided on the array plate and the adjoining plate. The coating reduces surface charging which otherwise can result in unwanted beam distortion.

The coating is configured to survive a possible electric breakdown event between the array plate and the adjoining plate. Preferably, a low ohmic coating is provided, and more preferably a coating of 0.5 Ohms/square or lower is provided. The coating is preferably provided on the surface of the downbeam plate. The coating is more preferably provided between at least one of the plates and the isolator. The low ohmic coating reduces undesirable surface charging of the plate.

The array plate and/or the adjoining plate may comprise a low bulk resistance material, preferably a material of 1 Ohm.m or lower. More preferably, the array plate and/or the adjoining plate comprises doped silicon. Plates having a low bulk resistance have the advantage that they are less likely to fail because the discharge current is supplied/drained via the bulk and not, for example, via the thin coating layer.

The array plate comprises a first wafer. The first wafer may be etched to generate the regions having different thicknesses. The first wafer may be etched in the region corresponding to the array of apertures, such that the array plate is thinner in the region corresponding to the array of apertures. For example, a first side of a wafer may be etched or both sides of the wafer may be etched to create the stepped thickness of the plate. The etching may be by deep reactive ion etching. Alternatively or additionally, the stepped thickness of the plate may be produced by laser-drilling or machining.

Alternatively, the array plate may comprise a first wafer and a second wafer. The aperture array may be defined in the first wafer. The first wafer may be disposed in contact with the isolator. A second wafer disposed on a surface of the first wafer in a region not corresponding to the aperture array. The first wafer and the second wafer may be joined by wafer bonding. The thickness of the array plate in the region corresponding to the array of apertures may be the thickness of the first wafer. The thickness of the array plate in another region, other than the region of the array of apertures, for example radially outward of the aperture array, may be the combined thickness of the first wafer and the second wafer. Thus, the array plate has a stepped thickness between the first wafer and the second wafer.

One of the array plate and the adjoining plate is upbeam of the other. One of the array plate and the adjoining plate is negatively charged with respect to the other plate. Preferably the upbeam plate has a higher potential than the downbeam plate with respect to for example to a ground potential, the source or of the sample. The electron-optical assembly may be configured to provide a potential difference of 5 kV or greater between the array plate and the adjoining plate. Preferably, the potential difference is 10 kV or greater. More preferably, the potential different is 20 kV or greater.

The isolator 730 is preferably disposed between the array plate and the adjoining plate such that the opposing surfaces of the plates are co-planar with each other. The isolator 730 has an inner surface 731 facing the path of the beamlets. The isolator 730 defines an opening 732, for the path of the electron beamlets.

A conductive coating may be applied to the isolator, for example coating 740. Preferably, a low ohmic coating is provided, and more preferably a coating of 0.5 Ohms/square or lower is provided.

The coating is preferably on the surface of the space facing the negatively charged plate, which is negatively charged with respect to the other plate. The downbeam plate is preferably negatively charged with respect to the upbeam plate. The coating shall be put at the same electric potential as the negatively charged plate. The coating is preferably on the surface of the isolator facing the negatively charged plate. The coating is more preferably electrically connected to the negatively charged plate. The coating can be used to fill any possible voids in between the isolator and the negatively charged plate.

In absence of such a coating on the isolator, electric field enhancement may occur in those voids. This electric field enhancement can result in electric breakdown in these voids and thereby in electric potential instability of the lower electrode. This potential instability results in varying lens strength over time, thereby defocusing the electron beams.

The inner surface 731 is shaped such that a creep path between the plates over the inner surface is longer than a minimum distance between the plates. Preferably, the inner surface of the isolator is shaped to provide a creep length of 10 kV/mm or less, preferably 3 kV/mm or less.

The exemplary electron-optical assembly 700 of Figure 6 comprises an isolator 730 defining an opening 732. The isolator 730 has a stepped thickness. The thickness of the isolator 730 in the region of the isolator closest to the path of the electron beamlets is less than the thickness of the isolator 730 in a region further from the path of the electron beamlets. In an arrangement, for example as depicted in Figure 6, the opening 732 of the isolator 730 has a larger width, which may be a diameter, on an upbeam side than on a downbeam side. That is in the isolator is defined an aperture or opening which may define a through passage having a surface. The through passage may have at least two different diameters at different positions along the beam path through the aperture. A stepped surface, for example between portions of the through passage having different diameters, is angled and preferably parallel to at least one of the array plate and the adjoining plate and/or orthogonal to the beam path. The isolator 730 has a larger surface area in contact with the downbeam plate 720 than the surface area in contact with the upbeam plate 710. In another arrangement, the opening defined in the isolator has a larger width on a downbeam side of the isolator than its upbeam side. One of the upbeam plate and the downbeam plate is positively charged with respect to the other plate. Preferably, the opening defined in the isolator has a larger width the side of the isolator closest to the plate which is positively charged with respect to the other plate.

The electron-optical assembly 700 may comprise or be a lens assembly for manipulating electron beamlets. The lens assembly may, for example, be, or may be part of, an objective lens assembly or a condenser lens assembly. The lens assembly, such as an objective lens assembly, may further comprise an additional lens array comprising at least two plates such as a control lens array 250.

Figure 7 is a schematic diagram of an electrical connector 60 of an exemplary electron-optical assembly 700. The electron-optical assembly 700 is configured to manipulate the electron beams. As shown in Figure 7, in an embodiment the electron-optical assembly 700 comprises a first electron-optical element comprising a plate 710. (Note if the electron-optical assembly 700 comprises just one first electron element, the first electron-optical element may be referred to as an or the electron-optical element).

In an embodiment the electron-optical assembly 700 comprises a plurality of electron-optical elements each comprising a plate. For example, the electron-optical assembly 700 shown in Figure 6 comprises a first electron-optical element comprising a plate 710 and a second electron-optical element comprising another plate 720. In an embodiment the electron-optical assembly 700 comprises more than two electron-optical elements each comprising a plate. The electrical connector 60 described in this document may be applied for connecting any or each of the plates 710, 720 of the electron-optical assembly 700 to an electrical power source (or power supply).

In an embodiment the plate 710 has one or more apertures 711 around a beam path of the electron beams. For example, as shown in Figure 6 in an embodiment the plate 710 comprises an array of apertures 711. In an alternative embodiment the plate 710 comprises only one aperture. Each aperture 711 may be for the beam path of a single electron beam. Alternatively, one or more apertures 711 may be around the beam path of a plurality of electron beams.

Figure 7 schematically shows an electrical connector 60. The electrical connector 60 is configured to electrically connect the plate 710 of the first electron-optical element to an electrical power source. In an embodiment the electron-optical device 40 comprises the electrical connector 60. In an embodiment the electron-optical assembly 700 comprises the electrical connector 60.

In an embodiment the electrical power source is a high voltage power source. In an embodiment the electrical power source is configured to apply a voltage of at least 100 V, optionally at least 200 V, optionally at least 500 V, optionally at least 1 kV, optionally at least 2 kV, optionally at least 5 kV, optionally at least 10 kV and optionally at least 20 kV to part of the electron-optical assembly 700 relative to a reference potential of the electron-optical device 40. In an embodiment the electrical power source is configured to apply a positive voltage relative to the reference potential. In an alternative embodiment the electrical power source is configured to apply a negative voltage relative to the reference potential. The reference potential may be ground. In an embodiment, one or more of the plates 710, 720 of the electron-optical assembly 700 is configured to be connected to high voltage during use of the electron-optical device 40.

As shown in Figure 7, in an embodiment the electrical connector 60 comprises a shield 61. The shield 61 is configured to define a field free region 62. The field free region 62 is substantially free of electric fields. In an embodiment the shield 61 is configured to shield an electrical component within the field free region from external electrical fields. In an embodiment the shield 61 is configured to reduce the possibility of electrical breakdown between an electrical component within the field free region 62 and another member of the electron-optical device 40.

In an embodiment the electrical connector 60 comprises a flexible coupling 63. The flexible coupling 63 is an electrical component. The flexible coupling 63 is electrically conductive. The flexible coupling is configured to electrically connect the electrical connector 60. The flexible coupling is configured to connect the electrical connector electrically to an electrical cable 64. The electrical cable 64 is connected to a power source The flexible coupling enables the electrical connector to be electrically connectable to the electrical cable 64. The flexible coupling may be in an electrical path between the plate 710 and the power source. In an embodiment the flexible coupling 63 is configured to electrically connect the plate 710 to the electrical power source, for example thereby enabling the electrical connector 60 to connect the plate 710 to the electrical power source. The plate 710 is electrically connectable to the electrical power source via the flexible coupling 63. Thus the plate 710 is electrically connectable by the electrical power source via to a cable. The electrical path may comprise: the electrical cable 64, the electrical connector 60 comprising for example the flexile connector 63 and the plate 710.

As shown in Figure 7, in an embodiment the flexible coupling 63 is located within the field free region 62 defined by the shield 61. The flexible coupling 63 is intended to provide an electrical connection to the plate 710 for example via an electrical connection to a conductive body such as the shield 61. The shield 61 is configured to shield the flexible coupling 63 from electric fields external to the shield 61. An embodiment of the invention is expected to reduce the possibility of electrical breakdown associated with the (electrical) connection of the electron-optical device to an electrical power source, for example between the electrical connector 60 and another component of the electron-optical device 40, for example another component of the electron-optical assembly 700.

It may be that during use of the electron-optical device 40, some electrostatic discharges occur. An embodiment of the invention is expected: to reduce the magnitude of any such discharges; and/or to reduce how damaging any such discharges may be. Small non-damaging discharges may occur while the electron-optical device 40 continues to perform its function desirably within a specification range of one more performance parameters. One or more performance parameters relate to aberrations such as geometry aberrations of the electron-optical device 40. One possible performance parameter is alignment. The alignment may have a specification range that electron-optical elements are parallel and flat within a tolerance of at most 100nm - 10µm in directions across (e.g. orthogonal to) the beam paths. Another possible performance parameter is axial misalignment (i.e. misalignment of an electron-optical element in a direction parallel to the beam paths). The axial misalignment may have a specification range that electron-optical elements are located along the electron-optical axis within a tolerance of at most 50-500nm.

The flexibility of the flexible coupling 63 reduces the possibility of the electrical connector 60 undesirably affecting the position and/or formation (e.g. shape) of the plate 710. Such a flexible coupling connected to the electron-optical device may reduce the risk of a force and/or moment being applied to the electron-optical device. Application of such a force or moment may undesirably influence the electron-optical performance of the electron-optical device during operation of the device. Such an influence in performance of the electron-optical device is observable from for example the position of the device, and thus alignment of the device so of the sample, relative to one or more the charged particle beams and between charged particle beams, and other aberrations. Such aberrations may be caused by, for example, changes to stresses within the device and/or the formation of the device, such as through deformation of the shape of an element of the device, causing distortions to the fields generated in the device.

An embodiment of the invention is expected to allow for more accurate positioning of the electron-optical assembly 700. An embodiment of the invention is expected to reduce the forces and/or moments applied to the electron-optical assembly 700 by the electrical connector 60. An embodiment of the invention is expected to reduce any undesirable deformation of the electron-optical assembly 700 by the electrical connector 60. For example, the flexibility of the flexible coupling 63 may reduce the possibility of the plate 710 deforming and thereby reducing in flatness (or deforming the plate away from a planar element). It is desirable to align the plate 710 with other components of the electron-optical device 40 and/or the electron beams. An embodiment of the invention is expected to improve the accuracy of alignment of the plate 710. Thus performance parameters may be, in a non-limited list: the accuracy of the alignment of the plate for example with respect to one more of the charged particle beams, the flatness and/or extent of deformation of the plate

As shown in Figure 7, in an embodiment the electrical connector 60 comprises the electrical cable 64. The electrical cable 64 is configured to electrically connect the flexible coupling 63 to the electrical power source. In an embodiment the electrical cable 64 comprises an insulator 65 surrounding a conductor 66. The conductor 66 is the transmission line. The insulator 65 is configured to insulate the conductor 66 from the environment.

In an embodiment the electrical cable 64 is a conductive cable, for example a coaxial cable, without the exterior insulator 65, for example outside shield. The exterior surface of a portion of the electrical cable without the insulator is a conductive surface of the conductor 66. In an arrangement the electrical cable 64 has had its outside shield removed, at least proximate to the flexible coupling, to reveal the conductive surface. Removal of the outside shield may allow a larger creep distance over the insulator 65 of the electrical cable 64. By increasing the creep distance, the possibility of electrons conducting by creeping over the surface of the insulator 65 may be reduced. As shown in Figure 7, for example, in an embodiment the isolating section, e.g. of the outside shield or insulator 65, of the electrical cable 64 is located in the field free region 62; that is the insulator 65 extends into the field free region until an end of the electrical cable 64. A surface of the conductor 66 within the electrical cable only provides a surface of the electrical cable at the end of the electrical cable 64. In a different embodiment, the outside shield of the electrical cable 64 extends into the field free region 62, short of the end of the cable, so that a portion of the conductor provides the exterior surface of the cable 64 between the end of the cable 64 and the insulator 65. The portion of the conductor is fully within the field free region 62. The conductor 66 of the electrical cable 64 is exposed only within the field free region 62. This reduces the possibility of electrical breakdown between the conductor 66 of the electrical cable 64 and another component of the electron-optical device 40.

In an embodiment the flexible coupling 63 is more flexible than the electrical cable 64 in at least one degree of freedom, optionally in at least two degrees of freedom, and optionally in all degrees of freedom. The flexible coupling 63 is configured to provide a lower stiffness connection to the plate 710 (and/or any other plate of the electron-optical assembly 700), optionally at high voltage.

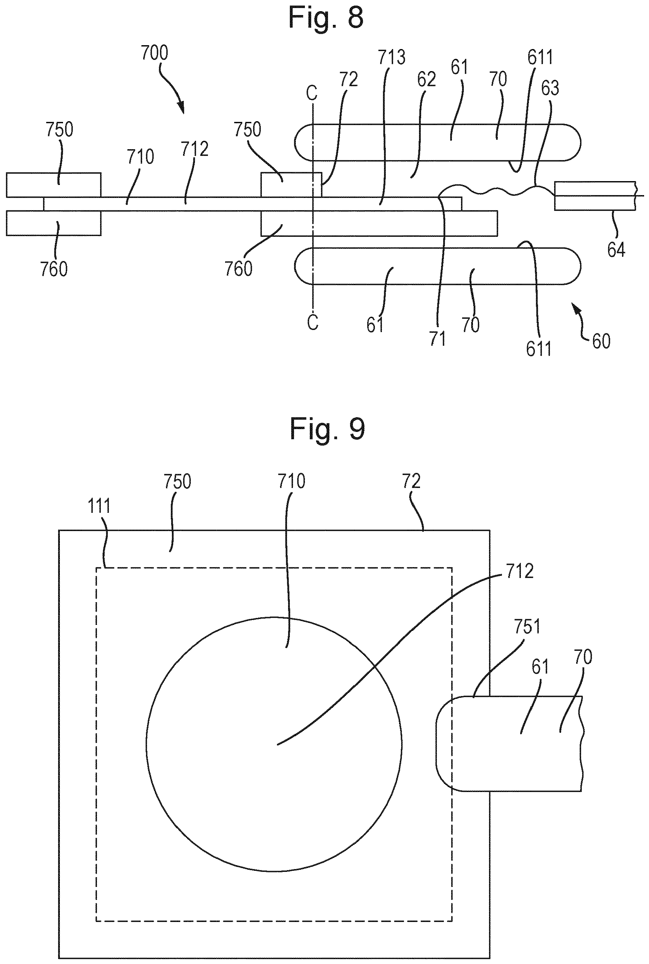

The electrical cable 64 may be relative stiff. As shown in Figure 7, in an embodiment the electrical cable 64 is mechanically connected to the plate 710 only via a lower stiffness component, for example the flexible coupling 63. In an embodiment the electrical cable 64 comprises the flexible coupling 63. The electrical cable 64 is not mechanically directly attached to the plates such as a first plate 710, and a second plate 720 (which may be an upbeam plate 710 and a downbeam plate 720 respectively) and/or isolators 750, 760 of the electron-optical assembly 700. The isolators may be referred to as a first isolator 750 and second isolator 760 which may respectively be referred to as an upbeam isolator 750 and a downbeam isolator 760. The isolator 750 has an outward periphery 72. Features relating to the outward periphery 72 of the isolator 750 will be described in more detail in relation to Figure 9. The electrical cable 64 may have a diameter of at least 0.1mm, optionally at least 0.5mm, optionally at least 1mm and optionally at least 2mm. The electrical cable 64 may have a diameter of at most 5mm. The electrical cable 64 may have a stiffness of at least 10,000N/m. The electrical cable 64 may have a stiffness of at most 100,000N/m. In an embodiment, an end 69 of the electrical cable 64, when electrically connected to the plate 710, is electrically connected with the shield 61. In an embodiment the shield 61 is a conductive body through which the electrical cable 64 electrically connects to the plate 710. A portion of the electrical cable 64 electrically connected to the shield 61 that extends out and away from the field free region 62 is at risk of discharge within the vacuum of the device, for example if the electrical cable 64 does not have, or has insufficient electrical insulation, and/or if the diameter of the electrical cable 64 is smaller than a threshold. The limitation to the diameter of the electrical cable 64 limits the flexibility of the electrical cable 64. The requirement of the electrical cable 64 to have a lower limit to its diameter requires the cable to have some stiffness which risks applying a force and/or moment to the electron-optical assembly 700 if the electrical cable is directly connected to the electron-optical assembly 700. Therefore, it is undesirable to connect the electrical cable 64 directly to the electron the electron-optical assembly 700 or to improve the flexibility of the electrical cable 64 itself.

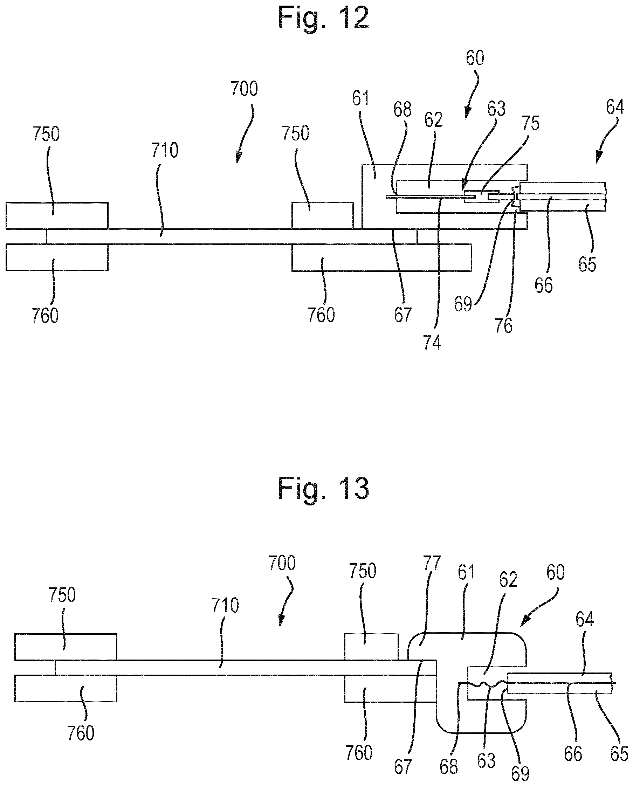

As shown in Figure 7, the shield 61 and the plate 710 may be connected to each other via a connection surface 67, for example a planar portion of the connection surface. Features of the connection surface 67 are described in more detail in relation to Figure 13. In an embodiment the flexible coupling 63 is connected to the shield 61 at a connection point 68. In such an embodiment the flexible coupling is secured to the shield 61 and connectable to the electrical cable 64. For example, in an embodiment the flexible coupling 63 is soldered to the shield 61 at the connection point 68.

In an embodiment the flexible coupling 63 comprises a wire. In an embodiment the flexible coupling 63 is made of a metal such as copper or bronze, such as phosphor bronze. In an embodiment the flexible coupling 63 has a diameter of at most 500 µm, optionally at most 200 µm, optionally at most 100 µm, and optionally at most 50 µm. In an embodiment the flexible coupling 63 has a stiffness of at most 10N/m, optionally at most 5N/m, optionally at most 2N/m and optionally at most IN/m. A thinner flexible coupling 63 may have a lower stiffness. The flexible coupling 63 may be at high voltage during use of the electron-optical assembly 700. The flexible coupling 63 is located in the field free region 62 so as to reduce potential problems with electrical discharges or partial electrical discharges. Thus the flexible coupling 63 is connected to the same potentials as the electrical cable 64 although it is more flexible because it is wholly contained within the field free region 62; the risk of electrical discharge associated with the connection of the electrical cable 64 to the electron-optical assembly is substantially reduced if not prevented by use of the flexible coupling.

The shield 61 comprises one or more surfaces 611 that define the field free region 62. The one or more surfaces 611 that define the field free region 62 may be at substantially the same potential difference (e.g. voltage) as the flexible coupling 63. The surfaces 611 of the shield 61 may be mechanically as well as electrically connected to the flexible coupling 63. In an alternative embodiment, the surfaces 611 of the shield 61 may be electrically connected to an electrical power source apart from the flexible coupling 63. There may be substantially no potential difference between the flexible coupling 63 located within the field free region 62 and the surfaces 611 of the shield 61 that define the field free region 62. It is possible that there may be some potential difference. In an embodiment the potential difference is small enough that there is negligible possibility of electrical breakdown between the flexible coupling 63 and the shield 61. Any such electrical breakdown is sufficiently small that it is not damaging.

In an embodiment the shield 61 comprises an electrically conductive material. The shield may consist of the electrically conductive materials for example the shield may be a solid body. In an embodiment an outer surface of the shield 61 is at substantially the same potential as the one or more surfaces 611 the define the field free region 62. As shown in Figure 7, in an embodiment the outer surface of the shield 61 comprises one or more rounded curves or corners 73. The outer surface of the shield may be a smooth continuous surface, for example without well-defined edges or corners. An embodiment of the invention is expected to reduce the possibility of electrical breakdown between the shield 61 and another component of the electron-optical device 40.

In an embodiment the length, e.g. depth of the field free region 62 is at least as great as the diameter of the field free region 62. In an embodiment the length of the field free region 62 is at least two times, and optionally at least five times, the diameter of the field free region 62. In general, electrical charges on a surface of an isolator located a distance away of at least five times the size of the gap to the source of the electric field may be irrelevant. This may be referred to as the 1:5 rule. In order for the field free region 62 to be substantially free of electrical fields, it is not expected to be necessary for the field free region 62 to have a depth that follows the 1:5 rule.

In an embodiment at least part of the shield 61 overlaps the plate 710 when viewed perpendicular to a plane across the beam paths. In an embodiment at least part of the shield 61 overlaps the plate 710 when viewed in a direction perpendicular to a plane of the plate 710. As shown in Figure 7, in an embodiment substantially all of the shield 61 overlaps the plate 710 when viewed in a direction perpendicular to the plane of the plate 710. It is not essential for there to be a full overlap. For example, as shown in Figures 8-13, in an embodiment the shield 61 only partially overlaps the plate 710 when viewed in a direction perpendicular to the plane of the plate 710. Any overlap can help to provide for a secure electrical connection between the plate 710 and the shield 61, for example as depicted in Figure 7, or between the plate 710 and the flexible coupling 63 located within the field free region 62 (e.g. see Figure 8).

As shown in Figure 7, in an embodiment the part of the shield 61 that overlaps the plate 710 is at only one of an upbeam side and a downbeam side of the plate 710. For example, in an embodiment the orientation of the electron-optical assembly 700 shown in Figure 7 is the same as the orientation of the electronic-optical device shown in Figures 2-5. The upper side of the diagram of the electron-optical assembly 700 in Figure 7 is the upbeam side. The downbeam side is below the diagram of the electron-optical assembly 700 shown in Figure 7. As shown in Figure 7, in an embodiment the overlapping part of the shield 61 is only at the upbeam side of the plate 710. The shield 61 contributes no distance to the extent to which the electron-optical assembly 700 extends in the downbeam direction. An embodiment of the invention enables the electron-optical assembly 700 to be connected to high voltage within the spatial constraints of the electron-optical device 40.

In an embodiment the electron-optical assembly 700 may be positioned proximate to the sample 208. For example the electron-optical assembly 700 may be an electron-optical lens assembly such as an objective lens assembly close to the sample 208. The shield 61 does not affect the position of the electron-optical assembly 700 relative to the sample 208.

In an alternative embodiment the part of the shield 61 that overlaps the plate 710 may be at only the downbeam side of the plate 710. In an embodiment the electron-optical assembly 700 may be positioned close to another electron-optical opponent located up beam of the electron-optical assembly 700. The shield 61 may be positioned with respect to the rest of the electron-optical assembly 700 so that the electron-optical assembly 700 may be freely positioned relative to the upbeam electron-optical component, for example to meet electron-optical requirements. That is the shield 61 may be positioned with respect to the electron-optical assembly 700 so as not to affect the position of the electron-optical assembly 700 relative to the upbeam electron-optical component.

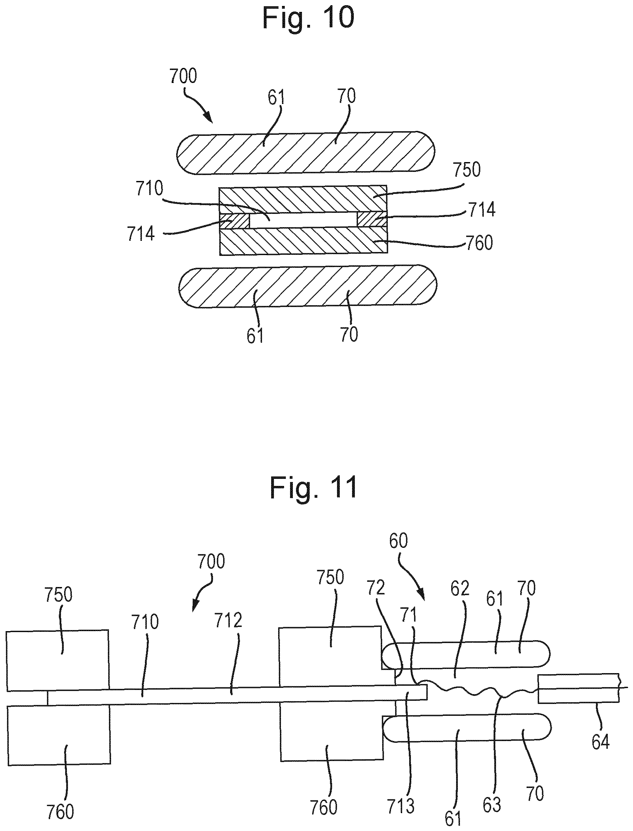

As shown in Figure 7, in an embodiment the plate 710 is configured to be electrically connectable to the flexible coupling 63 via the shield 61. The shield 61 is intermediate between the flexible coupling 63 and the plate 710 along the electrical path. The shield 61 may be positioned at only one side of the plate 710. This can reduce the amount of space taken up by the shield 61 in the direction of the electron beam paths. This arrangement may avoid additional electrical paths to the shield separate from the connection of the electrical cable 64 to the electron-optical assembly 700 for example as may be apparent from the description herein of the arrangements in at least Figures 8 and 11.

It is not essential for the plate 710 to be electrically connectable to the flexible coupling 63 via the shield 61. In an alternative embodiment, the plate 710 is connected to the flexible coupling 63 directly (e.g. see Figure 11) or via another component other than the shield 61.

As shown in Figure 7, in an embodiment the shield 61 is mechanically fixed relative to the plate 710 by a mechanical connection. The shield 61 is reliably and stably attached relative to the plate 710. The shield 61 may be comprised as part of the electron-optical assembly 700. In an embodiment the shield 61 is directly mechanically attached to the plate 710. Such a directly connected shield may be the conductive body. For example, the shield 61 may be connected to the plate 710 by a conductive adhesive and/or by a conductive weld. In an alternative or another embodiment the shield 61 may be mechanically connected to the plate 710 via an intermediate mechanical member. In an embodiment the shield 61 and the plate 710 are electrically connected to each other via the mechanical connection, for example via an electrically conductive layer, such as a metal layer and/or a coating, on one of the isolators upbeam or downbeam of the plate 710.

As mentioned above, in an embodiment the connection between the shield 61 and the plate 71 is made by adhering (e.g. gluing) the shield 61 with an electrically conductive adhesive directly on the plate 710. In an alternative embodiment the shield 61 may be adhered onto a conductive trace on one of the isolators 760 adjacent to the plate 710. The conductive trace may be an intermediate member between the plate 710 and the shield 61 for electrical connection. The conductive trace may provide at least part of an electrically conductive layer and may be a coating.

As shown in Figures 6-15, in an embodiment the electron-optical assembly 700 comprises at least one isolator 750, 760 adjacent to the plate 710. The isolator is configured to electrically isolate the plate 710 from one or more other plates of the electron-optical assembly 700 and/or from one or more other components of the electron-optical device 40. In an embodiment the isolator 750, 760 is mechanically connected to the plate 710. In an embodiment the isolator 750, 760 is configured to mechanically isolate the plate 710 from one or more other plates of the electron-optical assembly 700. One of the isolators 750, 760 may be positioned to be upbeam of the other isolator when the electron-optical assembly 700 is in the electron-optical device 40.

In an embodiment the isolator is substantially planar. The isolator 750, 760 and the one or more plates may be comprised in a stack within the electron-optical assembly 700. In an embodiment the isolator is substantially parallel to the plate 710.

As shown in Figure 7, the stack of the electron-optical assembly comprises a protruding element. The protruding element may comprise a protruding plate part of the plate 710 and/or a protruding isolator part. In an embodiment, as depicted, the downbeam isolator 760 comprises the protruding isolator part. In an embodiment the plate 710 comprises a protrusion 713 (or the protruding plate part); that is to say the protrusion is part of the plate 710. Alternatively the protrusion 713 is a separate electrically conductive planar piece connected to the plate 710. An outward perimeter of the stack is defined by one or more isolators 750, 760 and one or more plates having a common outward dimension in a plane orthogonal to the beam paths for example in of each of the primary axes of the plane orthogonal to the beam path or in a radially outward direction. The protrusion 713 extends beyond the outward perimeter . In an embodiment, the protrusion 713 thus protrudes beyond a radially outward periphery of the upbeam isolator 750, e.g. of the stack, with respect to the beam paths. In an embodiment the protrusion 713 protrudes beyond a radially outward periphery of the isolator 750 when viewed in a direction perpendicular to the plane of the plate 710. Desirably the shield 61 is secured to the protrusion 713. Desirably the protrusion 713 is shaped to correspond to a contact surface of the shield desirably in a plane across desirably orthogonal to the beam paths.

In an embodiment the electrical path is via an electrically conductive element on the surface of the downbeam isolator 760, that protrudes further outward desirably from the path of the plurality of charged particle beams. Note that the downbeam isolator 750 may be considered to comprise part of the protruding element, for example the protruding isolator part. Such a protruding isolator part may be a part of the periphery of the protruding isolating part of the downbeam isolator. (In a different embodiment, the upbeam isolator 750 comprises the protruding isolating part and optionally the downbeam isolator does not comprise part of the protruding element.) In an embodiment in which the plate 710 does not comprise a protruding plate part, the protruding element may comprise a protruding conductor part. The protruding conductor part is an electrically conductive layer (e.g. trace) on the protruding isolator part of the respective isolator 750, 760. Such a layer is electrically connected with the plate 710 directly or even via a different electrically conductive element. In such an embodiment, the protruding conductor part may be considered to be the protrusion 713. In such an arrangement, the plate does not protrude as much as the protruding isolating portion of, for example, the downbeam isolator 760, even that the plate extends no further outward as the outward periphery of the stack, for example as far outward as the upbeam isolator 750.

As shown in Figure 7, in an embodiment one of the isolators 750, 760, for example the downbeam isolator 760 may extend radially outwardly beyond the protrusion 713. The downbeam isolator 760 may be configured to electrically isolate the protrusion 713 of the plate 710, or the conductive layer which may replace the plate 710 as part of the protruding element, from components at the other side of the isolator 760. It is desirable to expose as little of the conductive plate 710, or the conductive layer, as possible so as to reduce the possibility of undesirable electrical breakdown. The protrusion 713 extends radially beyond the outward periphery of the other isolator 750 (e.g. the upbeam isolator 750 in the orientation shown in Figure 7) so as to allow for electrical connection of the plate 710. In an embodiment the protrusion 713 is formed unitarily with the plate 710. In an embodiment the protrusion 713 is a piece, tab or flap at the edge of the plate 710. The piece, tab or flap may extend up to an inward periphery of the isolators 750, 760. In an embodiment the protrusion has a curved radially outward periphery when viewed along the beam paths. Alternatively or additionally, the protrusion 713 may have a rectangular shape when viewed along the beam paths.

The protrusion 713 is configured to electrically connect the plate 710 to the electrical power source. In an embodiment a radially inward portion 712 of the plate 710 is electrically connectable to the flexible coupling 63 via the protrusion 713. The radially inward portion 712 is within the outward periphery of the isolator 750 beyond which the protrusion 713 protrudes. The protrusion may be in the electrical path between the plate 710 and the power source. In an embodiment, the protrusion 713 is the part of the plate 710, or a part that is in electrical contact with the plate 710 (for example if the protrusion is an electrically conductive layer on one of the isolators 750, 760) that provides for electrical connection. In an embodiment, the protrusion 713 is shaped to correspond to a shape of at least part of the shield 61, for example the conductive body, in a plane across desirably orthogonal to the beam paths. For example the protrusion 713 may be shaped to have a similar shape to a surface of the shield 61 that contacts the protrusion 713.

As shown in Figure 9, in an embodiment the radially inward section 712 of the plate 710 is exposed by an aperture in the isolators 750, 760. (Note only the upbeam isolator 750 is shown in this Figure. Features of the upbeam and downbeam isolators are the same unless specified to the contrary. A rim of the aperture defines the inward periphery of the isolator 750, 760. Figure 9 shows an arrangement in which the aperture is circular. A circular aperture helps to control the effect of the electric fields on the system for example because of the symmetrical shape of the aperture. Other shapes are possible but may be less desired. In general, smoother shapes are more desirable, for example with rounded corners. Rounded and fewer corners helps to reduce the concentration of electrical fields that would otherwise occur at sharp corners.

As mentioned above, in an embodiment the flexible coupling 63 comprises a wire. In an embodiment the wire 63 extends in an elongate direction. In an embodiment the wire comprises one or more bends for example because of the flexing of the wire. When the wire comprises one or more bends, the wire may extend generally in an elongate direction for example in an elongate dimension. This is shown, for example in Figures 7 and 8. It is not essential for the flexible coupling 63 to comprise a wire. In an alternative embodiment the flexible coupling 63 comprises a flexible electrical connector such as a flexible printed circuit. It is desirable that the flexible coupling 63 is sufficiently flexible that the flexible coupling deforms (for example flexes) in response to an applied force rather than applying the force to the when a force is applied to the electron-optical assembly 700.

As shown in Figure 7, in an embodiment the shield 61 is arranged to surround the flexible coupling 63 when viewed in at least one direction in the frame of reference, for example of the device 40. For example, when the arrangement shown in Figure 7 is viewed in a direction across the beam paths (i.e. in a direction within the plane of the plate 710), the shield 61 surrounds the flexible coupling 63. The shield 61 protects the flexible coupling 63 from the effects of electrical discharge, such as electrical breakdown, to external components to the electrical connector 60, for example of the electron-optical assembly or even the electron-optical device 40.

In an embodiment the shield 61 defines a recess configured to receive the flexible coupling 63. In an embodiment the recess corresponds to, and so may define, the field free region 62. The shield 61 is configured, for example shaped, to receive the flexible coupling 63. In an embodiment the shield 61 may be a conductive body in which the recess is defined. An aperture of the recess is defined in a surface of the conductive body, for example a side surface of the conductive body. The side surface may be orthogonal to the orientation of the plate and may have a common direction with the beam paths. The recess may be cylindrical. The aperture of the recess may have shape corresponding to a cross-section of the recess (e.g. cylinder). The flexible coupling may be positioned within the recess so that the elongate dimension of the flexible coupling 63 is along an axis of the recess (e.g. the cylinder). Thus the shield 61 may considered to provide the recess with a shape of an interior surface of a vessel (on its side in the orientation shown in Figure 7). In an embodiment, the recess has a substantially circular cross-section. The aperture of the recess may be circular. In an embodiment the flexible coupling 63 is located centrally to the recess, for example the elongate dimension of the flexible coupling extends centrally in the recess. It is not essential for the recess to have a circular cross-section. In an alternative embodiment the recess may have a cross-section of any shape such as a square, rectangular or hexagonal cross-section. However a circular cross-section of the recess may be preferred for manufacturing reasons and otherwise has smooth, curved surfaces avoiding sharp edges which may risk of unwanted discharge; so the cross-sectional shape desirably has few corners and/or rounded corners. The cross-section of the recess may be orthogonal to the depth (i.e. length direction) of the recess.

In an embodiment the recess is configured to have a surface concentric with the elongate direction of the flexible coupling 63. The flexible coupling 63 may be positioned so that it is distanced from the surface of the shield 61, for example the surface 611 of the recess that defines the field free region 62 (except for where the flexible coupling 63 is connected to the shield 61).

Figure 8 is a schematic diagram of an electrical connector 60 in an exemplary electron-optical assembly 700. The features of the electrical connector 60 and the exemplary electron-optical assembly may the same or similar to the arrangement shown in and described with reference to Figure 7 unless explicitly stated to the contrary. As exemplified in the arrangement shown in Figure 8, it is not essential for the shield 61 to be arranged to surround the flexible coupling 63. In an alternative embodiment the shield 61 comprises two planar members 70 defining the field free region 62 between them. In an embodiment the planar members 70 extend substantially parallel to the plate 710. In an embodiment the planar members 70 are positioned on either side of the plate 710 for example in the direction of the beam path. The protrusion 713 of the plate 710 is located between the planar members 70 of the shield 61. The protrusion 713 is shaped to correspond a shape of the shield 61 in a plane across desirably orthogonal to the beam paths. Desirably the shield has a larger size than the protrusion.

In an embodiment the length, e.g. depth, of the field free region 62 is at least as great as the size of the gap between the planar members 70. In an embodiment the length of the field free region 62 is at least two times, and optionally at least five times, the size of the gap between the planar members 70. In general, electrical charges on a surface of an isolator located a distance away of at least five times the size of the gap to the source of the electric field may be irrelevant. This may be referred to as the 1:5 rule. In order for the field free region 62 to be substantially free of electrical fields, it is not expected to be necessary for the field free region 62 to have a depth that follows the 1:5 rule.

As shown in Figure 8, in an embodiment the plate 710 is between two isolators 750, 760 one of which may upbeam of the other. In an embodiment the isolators are substantially planar, so the plate 710 may be considered to be sandwiched between the two isolators 750, 760. In an embodiment the isolators 750, 760 comprise a dielectric material such as glass or quartz. Part of the surface of the plate 710 is covered by, for example in contact with, the dielectric material of the isolators 750, 760. The radially inward portion 712 is exposed and is for the passage of the electron beams. The edge of the protrusion 713 remains exposed (i.e. uncovered) to allow for electrical connection of the plate 710 (or electrically conductive layer) for example with the flexible coupling 63.

Figure 10 is a cross-sectional view of an embodiment of the electrical connector 60 shown in Figure 8. Figure 10 is a cross-sectional view taken along the line C-C shown in Figure 8, so for example of the electrical connector when viewed along the direction of the elongate dimension of the flexible coupling 63. As shown in Figure 10, in an embodiment the isolators 750, 760 have a larger dimension than the plate 710 in the direction across the electron beams. In an embodiment a dielectric 714 is provided at the minor surfaces of the plate 710 between the isolators 750, 760; that is the dielectric may be positioned at the lateral sides of the plate for example for covering the minor surfaces of the plate 710. In an embodiment the dielectric 714 comprises an adhesive. In an embodiment the dielectric 714 comprises a material that hardens when cured (e.g. when subjected to UV radiation). In an embodiment the dielectric comprises an adhesive or an epoxy. In an embodiment the dielectric 714 is formed by capillary filling a gap, for example a lateral gap, around an outer periphery of the plate 710 between the isolators 750, 760. In an embodiment the material that forms the dielectric 714 is low viscosity so as to help with filling the gap. Desirably the filling of the lateral gap is complete so that the lateral gap is filled with the dielectric. Therefore, desirably the dielectric is without voids which may be source of electrical breakdown. The dielectric 714 is configured to electrically isolate the plate 710 from external components to the electron-optical assembly of the electron-optical device 40 and from other components of the electron-optical assembly.

In an embodiment the dielectric 714 comprises an epoxy adhesive. In an embodiment the adhesive is UV curable. It is desirable for the dielectric 714 to have relative low outgassing after curing which may otherwise, for example, be a source of voids within the dielectric. Such a dielectric material may be applied to other surfaces of the plate 710 which may otherwise be undesirably exposed. For example, any part of the plate 710 not covered by the shield 61 or isolator radially outward of the isolator, relative to the beam paths, may have such a protective layer such as a coating.

In an embodiment the only parts of the plate 710 that are exposed (or uncovered) are the radially inward portion 712 and part of the protrusion 713. In a different embodiment, the only part of the plate that is exposed is the radially inward portion 712. The protrusion 713 may be exposed but be an electrically conductive layer on the protruding isolator part and in electrical contact with the plate 710. As shown in Figures 8 and 10, in an embodiment the protrusion 713 is located within the field free region 62. The planar members of the shield 61 extend further inward than the outer periphery of the stack. The planar shields extend further outward than the protrusion 713. The width of the of the protrusion is smaller than the width of the shields. The surfaces 611 (or facing surfaces) of the shield facing towards the protrusion 713 define the field free region 62. In effect within the electrical connector 60, desirably the flexible coupling and an exposed (or uncovered) portion of the protruding conductive part (or the protrusion 713, i.e. of the plate 710 or the electrically conductive layer in electrical contact with the plate 710) are within the field free region 72. Such a field free region substantially reduces, if not prevents, the exposure of components within the field free region from external electrical fields.

As mentioned above, surfaces of the plate 710 may be covered by dielectric materials such as the isolators 750, 760 and the dielectric 714. This helps to lower the electrical field near the edges of the plate 710 and/or shape the electrical field near the edges of the plate 710. The use of such dielectric materials may further improve the field free region in reducing the exposure of external fields within the field free region.

Figure 10 is a schematic diagram of an electrical connector 60 in an exemplary electron-optical assembly 700. The description of the electrical connector 60 and electron-optical assembly shown in and described with reference Figures 8 and 10 (and thus in turn of Figure 7) may apply unless stated expressly to the contrary. As shown in Figure 11, in an embodiment the isolators 750, 760 are thicker than the planar members 70 of the shield 61. The isolators 750, 760 have a dimension greater than that of the planar members 70 of the shield 71 in a direction along the electron beams. In an embodiment the planar members 70 are in mechanical contact with the isolators 750, 760. In an embodiment the flexible coupling 63 is electrically connected to the planar members 70 of the shield 61.

As mentioned above, in an embodiment the plate 710 comprises a protrusion 713 which protrudes beyond an outward periphery of the isolator 750. (See for example Figure 11.) In an alternative embodiment a protrusion 713 is not required. The isolators 750, 760 on both sides of the plate 710 may have outward peripheries beyond the outward periphery of the plate 710. (This arrangement is not depicted in cross-section; such an arrangement may take the features shown in and described with reference to Figures 8, 10 and 11, except the outward periphery of the isolators is outward of the outer periphery of the plate 710.) For example, when the isolators 750, 760 are thicker than the planar members 70 of the shield 61 (e.g. as shown in Figure 11), then the planar members 70 may be arranged to have an overlap with the plate 710 within a footprint of the stack, for example when considered in a plane orthogonal to the direction of the beam paths. Such an arrangement is shown in Figure 9. (Note the application of Figure 9 to an embodiment shown in and described with respect to Figures 8, 10 and 11 may be different considering the cross-section C-C in Figure 8; therefore Figure 9 is being referred to with respect to a different embodiment.) An embodiment within the scope of disclosure of Figure 9 is a plan view of an electrical connector 60 of an exemplary electron-optical assembly 700 in which the plate 710 is recessed within the stack and with respect to the outward periphery of the isolators. As shown in Figure 9, in an embodiment the planar members 70 of the shield 61 extend inward for example towards the path of the beams, across the outward periphery 72 of the isolator 750. The planar members of the shield 61 extend inward beyond the outward periphery 111 of the plate 710 desirably relative to the paths of the one or more charged particle beams. This allows the outward periphery 111 of the plate 710 to be within the outward periphery 72 of the isolator 750.

It is possible that the protrusion 713 is not required to protrude outward of the outward periphery of the stack. In an embodiment, the protrusion 713 is an indentation, for example provided by a cut out portion, of the periphery of an adjoining isolator 750, 760. For example, a cut out may be provided that conforms to, or within, the shape of a periphery 751 of the shield 61, for example within the periphery of the planar member 70 of the shield. The periphery 751 of the shield 61 may be of an inwardly extending portion of the periphery of the shield. The protrusion 713 may therefore protrude outward of the isolator with the indentation. By providing an indentation, the protrusion 713 of the plate 710 is available for electrical connection, for example the protrusion is exposed (uncovered) for electrical connection to the flexible coupling.

In an embodiment the shield 61 is arranged such that the field free region 62 has a greater dimension in a direction across the beam paths (e.g. a direction parallel to a plane of the plate 710) than in a direction along the beam paths (e.g. a direction perpendicular to the plane of the plate 710). The electrical connector 60 is configured to electrically connect the plate 710 to an electrical power source away from the beam paths of the electron beams. The electrical path extends generally away from the beam paths in a radial direction from the electron-optical device 40.

Figure 12 is a schematic diagram of an electrical connector 60 of an exemplary electron-optical assembly 700. Some features of the electron-optical assembly 700 and electrical connector 60 shown in Figure 12 are the same as those described above and shown in, for example, Figure 7. Description of these features will not be repeated so as to avoid redundant description. Such features of the embodiment shown in Figure 12 should be considered to be substantially the same as shown in and described with reference to Figure 7 unless stated to the contrary.

Figure 12 shows an electrical connector 60 suitable for making an electrical connection by a mechanically compliant mechanism. The connection may be a high voltage connection. As shown in Figure 12, optionally the flexible coupling 63 comprises a wire 74. The wire 74 is made of an electrically conductive material. For example, in an embodiment the wire 74 comprises bronze, such as phosphor bronze. In an alternative embodiment the wire 74 comprises copper, for example. In an embodiment the wire 74 is compliant in at least one degree of freedom, optionally in at least two degrees of freedom and optionally in five degrees of freedom.

As shown in Figure 12, in an embodiment the flexible coupling 63 comprises a resilient element 75. In an embodiment the resilient element is resilient in a degree of freedom. In particular, the resilient element 75 is resilient in a different degree of freedom from the degrees of freedom in which the wire 74 is compliant. In an embodiment the flexible coupling 63 comprising the wire 74 and the resilient element 75 is compliant in all six degrees of freedom.

In an embodiment the flexible coupling 63 has an elongate direction, for example with an elongate dimension. In an embodiment the resilient element 75 is resilient in a degree of freedom corresponding to the elongate direction of the flexible coupling 63. The elongate direction of the flexible coupling 63 may be the direction in which the wire 74 is less compliant.

As shown in Figure 12, in an embodiment the resilient element is spring-loaded, for example a spring-loaded element which may be referred to as a pogo pin. The pogo pin may be connected to the wire 74, for example by soldering. In an embodiment the flexible coupling 63 is configured to be positionable with respect to the shield 61 in at least five degrees of freedom.

In an embodiment the flexible coupling 63 is connected to the shield 61 at a connection point 68. In such an embodiment the flexible coupling is secured to the shield and connectable to the electrical cable 64. For example, in an embodiment the electrical connector 63 is soldered to the shield 61 at the connection point 68. The wire 74 may be soldered to the shield 61. The flexible coupling 63 is electrically connected to the electrical cable 64 at a connection point, for example at the end 69 of the electrical cable 64. As shown in Figure 12, in an embodiment the electrical cable 64 comprises a landing pad 76 or more generally a connecting surface. The landing pad may be located at the end 69 of the electrical cable 64. The connecting surface, or more specifically the landing pad 76 is configured to receive the resilient element 75. The resilient element 75 is directly electrically connected to the landing pad 76 of the electrical cable 64. In an embodiment the landing pad may be a recessed surface. The recessed surface is recessed towards the center of the surface. The center of the surface may be most deeply recessed. The center of the surface may be referred to as a connection point. On positioning the landing pad and the spring loaded pin together, the resilience of the spring loaded pin may be sufficient to resist compressing the pin to disengage the pin from the pad, for example at the connection point, such that the pin and pad remain engaged and any forces in the direction of the pin are absorbed by the resilience of the pin rather than applied to the electron-optical assembly 700.

In an alternative embodiment not shown in the Figures, the orientation of the flexible coupling 63 is reversed. The wire 74 may be between the resilient element 75 and the electrical cable 64. The resilient element 75 may be located between the shield 61 and the wire 74. In such an arrangement, the landing pad 76 may be provided at the surface of the shield 61 to form the connection point 68. In such an embodiment the flexible coupling 63 is secured to the electrical cable 64 and connectable to the shield 61.

In an embodiment, the shield 61 (which may also be referred to as an HV cover (cover for high voltage) has a greater diameter than the diameter of the electrical cable 64. In an embodiment the shield 61 has at least a partially rounded outer surface. This can help to reduce the electric field on the outside of the shield 61 and thereby prevent electrical discharges.

In an embodiment the shield 61 is bonded to the plate 710 (or the electrically conductive layer). For example, in an embodiment the shield 61 is soldered to the plate 710. Solder provides a good electrical contact within a limited volume and is also suitable for vacuum conditions.

In an embodiment the flexible coupling 63 can be disconnected from and reconnected to at least one of the electrical cable 64 and the shield 61. For example, in the embodiment shown in Figure 12, the flexible coupling 63 can be readily disconnected from the electrical cable 64. The pogo pin or other type of resilient element 75 may be released from the landing pad 76 at the end 69 of the electrical cable 64. This can make it easier to replace the electron-optical assembly 700 within the electron-optical device 40. In an alternative embodiment in which the orientation of the flexible coupling 63 is reversed, the flexible coupling 63 may be readily disconnected from the connection point 68 to the shield 61.

In an embodiment there is provided a method of disconnecting an electron-optical assembly 700 from an electron-optical device 40. The method comprises electrically disconnecting the plate 710 from the electrical power source by disconnecting the flexible coupling 63 from the electron-optical assembly 700 or from the electrical power source. When the flexible coupling 63 is disconnected from the electrical power source, the flexible coupling 63 may remain connected to the electron-optical assembly 700. Alternatively, when the flexible coupling 63 is disconnected from the electron-optical assembly 700, the flexible coupling 63 may remain connected to the electrical power source.

In an embodiment the method further comprises disconnecting the electron-optical assembly 700 from the electron-optical device 40. The electron-optical assembly 700 may be replaced with a replacement electron-optical assembly. The replacement electron-optical assembly may be connected to the electrical power source and the rest of the electron-optical device 40. For example, the flexible coupling 63 may be reconnected to the electrical power source or the replacement electron-optical assembly.

Figure 13 is a schematic diagram of an electrical connector 60 of an exemplary electron-optical assembly 700. Possible features of an electron-optical assembly 700 and an electrical connector 60 described elsewhere in this document may be applied to the electron-optical assembly 700 and the electrical connector 60 shown in Figure 13. The features of Figure 13 may be the same as any of the embodiments shown in and described with reference to Figures 7 to 12, Figure 13 is provided to illustrate features of the electrical connector 60 which may be applied to other embodiments described elsewhere in this document.

As shown in Figure 13, in an embodiment the shield 62 is arranged such that the field free region 62 is situated adjacent a surface of the plate 710 in a plane across the beam paths. In an embodiment, as depicted in Figure 13, the shield may be secured to the plate 710 and may be a conductive body in which is defined a recess of the field free region 62 for the flexible coupling 63 but the specific features may relate to other embodiments such as those disclosed herein. In an embodiment the field free region 62 at least partially overlaps the plate 710 when viewed in a direction within the plane of the plate 710. Alternatively expressed, the field free region is at least in part in the sample plane of the plate 710. Having the field free region extending into the same plane as the plate may help to reduce the extent to which the shield 61 extends in a direction along the beam path and/or orthogonal to the plate. This helps reduce if not minimize the distance above and/or below the plate 710. As shown in Figure 13, in an embodiment the shield 61 may extend as far upwards as, for example not extend any further upwards than, the upbeam isolator 750. In an embodiment (not depicted) the shield 61 may extend as far downward as the downbeam isolator 760. The exact arrangement of the shield 61 relative to the plate 710 may be selected depending on the space constraints of the electron-optical assembly 700 for example of the volume available in the electron-optical device 40 for the electron-optical assembly 700.

As shown in Figure 13, in an embodiment the shield 61, for example the conductive body, comprises an inwardly protruding edge portion 77 or a protruding shelf portion. The protruding edge portion 77 is shaped with a surface that corresponds to a planar surface of the protrusion and a side surface of the protrusion. The protruding edge portion 77 is configured to provide the mechanical and/or electrical connection between the shield 61 and the plate 710 and optionally the protruding isolator part of the protrusion 713. As shown in Figure 13, the shield 61 and the plate 710 may be connected to each other via a connection surface 67, for example a planar portion of the connection surface. The connection surface 67, for example a side portion of the connection surface 67 may also connect the shield 61 to the side surface protrusion, for example the plate 710 and/or the isolator 760. By providing a connection surface 67, the mechanical and/or electrical connection between the plate 710 and the shield 61 may be made robust, reliable and secure. Such a connection surface 67 between the shield 61 for example as a connective body, or conductive body, to a planar portion of a connection surface 67 is also shown in Figure 7 and Figure 12.

As shown in Figure 13, in an embodiment the shield 61 comprises an indentation, such as cut out portion. The cut out portion may be defined below the protruding edge portion 77. The indentation may be shaped to correspond to a part of an inward periphery of the shield desirably the protruding edge portion. The indentation may be shaped to receive at least part of the inward periphery of the protruding edge portion of the shield. At least part, desirably an inward part, of the planar of the connection surface 67 may be shaped to correspond to indentation. The cut out shape is to allow for the mechanical and/or electrical connection to the plate 710.

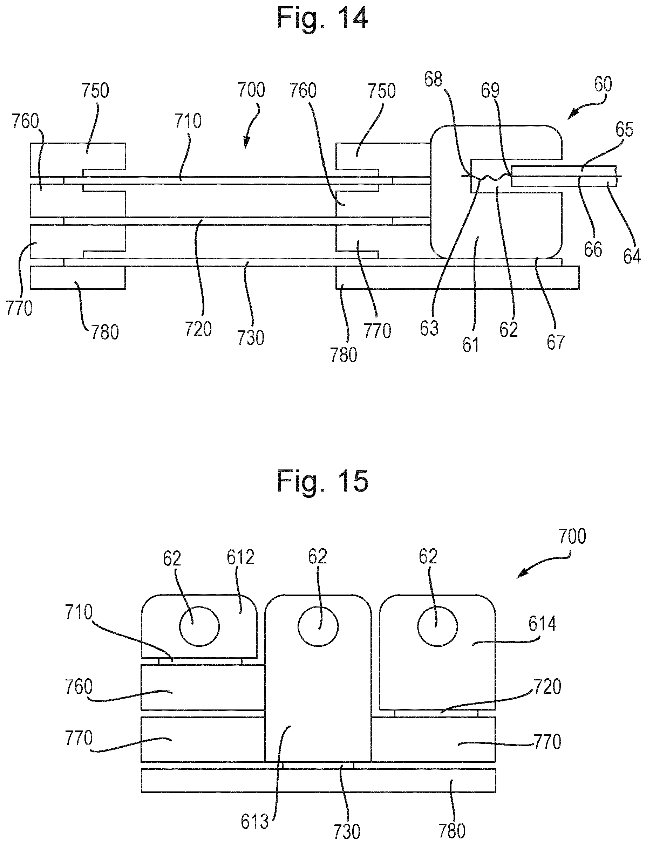

As shown in Figure 6 and Figure 14, in an embodiment the electron-optical assembly 700 comprises a second electron-optical element comprising a plate 720. The electron-optical assembly 700 may have the same features with similar function as depicted and herein described with reference to Figures 7 to 13. The plate 720 has one or more apertures around a beam path of the electron beams. Figure 14 shows an arrangement of an electron-optical assembly 700 further comprising a third electron-optical element comprising a plate 730. Although three plates 710, 720, 730 are shown in Figure 14, in an embodiment the electron-optical assembly 700 may comprise more than three plates. Each plate may be separately connected to an electrical power source. One or more of the plates may be connected to a high voltage power source such that the potential difference between the surfaces of the plates can be controlled to control the electric fields adjacent to the plates. Each plate may be provided with its own electrical connector 60. In an arrangement multiple plates have a common electrical connector 60, so have a common electrical connection.

Figure 15 is a schematic diagram of a side on view of the arrangement shown in Figure 14. Figure 15 shows the three shields 61 of the three electrical connectors for three of the plates 710, 720, 730 which may be referred to as an upbeam plate 710, an intermediate plate 720 and an downbeam plate 730. The shields may be referred to as a left most shield 612, a middle shield 613 and a right most shield 614. Each shield 612-614 defines a field free region 62. In the conductive body of the respective shield 612-614 a recess defines the field free region 62.

As shown in Figure 15, in an embodiment each shield 612-614, for example conductive body, is mounted on a respective plate 710, 720, 730. The electron-optical assembly 700 shown in Figure 14 and Figure 15 comprises further isolators 770, 780 adjacent to the further plates 720, 730, for example so that each plate 710, 720, 730 has two adjoining isolators which are upbeam and downbeam of an individual plate. An isolator may function as an upbeam isolator and a downbeam isolator for respective adjacent plates along the beam paths. For example the upbeam plate 710 has adjoining isolators 750, 760; intermediate plate 720 has adjacent isolators 760, 770; and downbeam plate 730 has adjoining isolators 770, 780. In the arrangement shown in Figure 15, the left most shield 612 is connected to the up beam plate 710 for connecting the upbeam plate 710 to an electrical power source. The middle shield 613 shown in Figure 15 is for connecting the down beam plate 730 to an electrical power source. The right-most shield 614 shown in Figure 15 is for electrically connecting the intermediate plate 720 to an electrical power source. In an embodiment the shields 612-614 are electrically isolated from each other. Alternatively, the shields 612-614 may be electrically connected to each other.

As shown in Figure 15, optionally the electrical connectors 60 are arranged such that the shields 612-614 define respective field free regions 62 that overlap each other in a direction along the beam paths. When the electrical connectors 60 are viewed from the side (as in the view shown in Figure 15), i.e. in a direction parallel to the planes of the plates 710, 720, 730, the field free regions 62 overlap each other, desirably in substantially the same plane for example at the same position along a direction of the beam path. This may help to simplify the connection of the plates 710, 720, 730 to different potentials.

In a different arrangement of the electron-optical assembly 700, the plate 710 and the isolators 750, 760 extend no further outward than the periphery of the stack. In such an arrangement, the connection surface 67 only has a side portion for example it does not have a planar portion. The side portion comprises at least a side surface of the plate 710 (or a conductive layer in the plane of the plate) and at least one adjoining isolator which may be the upbeam and/or downbeam of the plate 710. The stack is without a protrusion, as such, although the plate or alternatively the conductive layer in electrical connection with plate 710, may extend to a periphery surface of the stack at the side portion in place of dielectric, which may be present elsewhere in the plane of the plate 710 at the periphery of the stack. The shield 61 has a surface shaped to correspond to the side portion of the connection surface. Such an arrangement avoids the need for protrusions and directly connects to the plate, or an electrically conductive layer in the plane of the plate and is mechanically secured to the stack via the peripheral surface of at least one isolator. The plate and/or a conductive layer may extend partially along the peripheral surface of an adjoining isolator to increase the electrical contact between the plate 710 and the shield 61. To ensure a secure connection, the shield may be mechanically connected to other plates (or electrically conductive layers) via a dialectic layer to ensure that the shield 61 and each other plate is electrically isolated. However, such an arrangement of an electrical connector 60 although available may have a less secure mechanical connection of the shield to the electron-optical assembly than an electrical connector with a protrusion 713.

In an embodiment the electron-optical assembly 700 comprises one or more electron-optical elements which comprise an element which may be referred to as a microelectromechanical component (despite such component may not comprise a moving or moveable feature) or may be made using techniques suited to make microelectromechanical components (for example a 'MEMS technique') some of which are designed to have electron-optical functionality. The electron-optical assembly 700, or at least components of the electron-optical assembly 700, may be manufactured by such techniques. The electron-optical assembly 700 may comprise one or more elements which may be considered MEMS elements. One or more of such elements may be controlled to be set at a high potential difference relative to a reference potential (e.g. ground) during use. Such elements may require accurate positioning (for example alignment) within the electron-optical assembly 700 for example with respect to the path of the beam grid and with respect to other electron-optical elements within the device for example with respect to a source, with respect to a sample and/or the path of the beam grid. An embodiment of the invention is expected to allow for more accurate positioning (for example alignment) of such elements within the stack of such an electron-optical assembly 700 such as during operation for example without distortion of the electron-optical assembly 700 for example by externally applied force or moment. An embodiment of the invention may in addition or alternatively enable more accurate positioning, for example alignment, of such elements with respect to other elements in the device 40 and thus of the stack of the electron-optical assembly 700 comprising such elements within the device 40.

As mentioned above, in an embodiment the electron-optical assembly 700 is an electron-optical lens assembly. The electron-optical lens assembly may comprise an objective lens assembly. The electron-optical lens assembly may be an objective lens assembly. In an alternative embodiment the electron-optical lens assembly is an electron-optical condenser lens assembly.

In an embodiment the electron-optical assembly 700 comprises a collimator. For example, in an embodiment the electron-optical assembly 700 comprises a magnetic collimator in combination with an electro static condenser lens arrays. The electron-optical assembly 700 may comprise a single aperture lens array with one or two macro electrodes, placed away from the virtual source conjugate plane.

In an alternative embodiment, the electron-optical assembly 700 comprises a magnetic macro lens in combination with an electrostatic slit deflector. The magnetic macro lens may be for collimating. As a further alternative, in an embodiment the electron-optical assembly 700 comprises a combined magnetic and electrostatic macro lens and a downbeam slit deflector.

In general, the electron-optical assembly 700 may comprise any plates such as a plate of a detector array, a plate of a lens electrode (into which multiple deflectors may be integrated) multiple deflector arrays, beam aperture arrays (e.g. an upper beam aperture array and/or a final beam limiting array), deflector arrays (e.g. strip deflector arrays) and other types of corrector elements.

The embodiments described within this document have focused primarily on multi-beam electron-optical devices 40. The invention is equally applicable to single-beam electron-optical devices 40.

In an embodiment a plurality of electrical connectors 60 may be provided for the same plate. For example, it may be that the plate 710 comprises different electrodes that have different potentials applied during use of the electron-optical assembly 700. For example, in an embodiment the plate 710 is of a strip electrode, where each electrode of the strip electrode has or may have a different electrical potential applied. In a different embodiment, alternate electrodes may have commonly applied potentials, so adjacent electrodes have different applied potentials. There may be more than one electrical connector 60 per plate 710. Similarly, a deflector having a multi-pole of electrodes can require different potentials applied to the plate for the different electrodes; for example the plate may comprise a plurality of deflectors, common electrodes of the different deflectors having a common electrical connector 60..

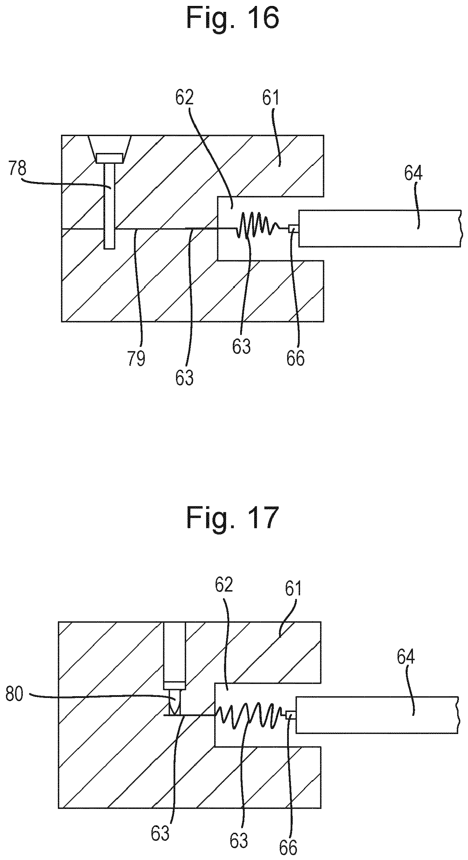

As shown in Figures 7 and 12-14, in an embodiment the flexible coupling 63 is connected to the shield 61 at a connection point 68 and to the electrical cable 64 at another connection point, for example at the end 69 of the electrical cable 64. Figure 16 is a schematic diagram showing an example of how the flexible coupling 63 may be connected to the shield 61 and the electrical cable 64. The features of the electrical connector 60 shown and described with reference to Figure 16 may apply to any other embodiment disclosed herein, for example as shown in and described with reference to Figures 7 and 12-14. In an embodiment the flexible coupling 63 is connected to the shield 61 by a clamp for example a bracket clamp. In an embodiment the shield 61 forms the clamp for example comprising two parts, namely an upper part and a lower part. The shield 61 comprises upper and lower brackets (i.e. the upper part and lower part respectively). The upper and lower brackets may be initially formed as separate components and subsequently joined together to form the shield 61, for example the conductive body of the shield. Figure 16 shows a join 79 between the two parts of the shield 61. As shown in Figure 16, in an embodiment a fixator such as fixing component 78 is provided to secure the two brackets of the shield 61 together.

In an embodiment, one end of the flexible coupling 63 is located between the two brackets of the shield 61. The flexible coupling 63 may be between, for example sandwiched between, the two parts of the shield 61. The end of the flexible coupling 63 is located in the join 79 of the shield 61. The flexible coupling 63 may be positioned on the lower bracket with the upper bracket subsequently placed on top of the lower bracket and the flexible coupling 63. The fixing component 78 is then applied to secure the flexible coupling 63 in position relative to the shield 61. In an embodiment the fixing component comprises a pin, a nail or a screw, for example.

As shown in Figure 16, in an embodiment the other end of the flexible coupling 63 may be connected to the conductor 66 of the electrical cable 64. In an embodiment the flexible coupling 63 is crimped onto the conductor 66. Alternatively, the flexible coupling 63 may be welded, adhered or friction fitted to the conductor 66 of the electrical cable 64.

Figure 17 is a schematic diagram of an alternative way of connecting the flexible coupling 63 to the shield 61. As shown in Figure 17, in an embodiment the flexible coupling 63 is connected to the shield 61 by a fixator such as a compressive fixator for example by a set screw 80. In an embodiment the shield 61 comprises a recess for accommodating the set screw 80. In an embodiment the shield 61 comprises another recess for accommodating the end of the flexible coupling 63. The set screw 80 is inserted to pin (or compressively secure) the end of the flexible coupling 63 in the recess of the shield 61.

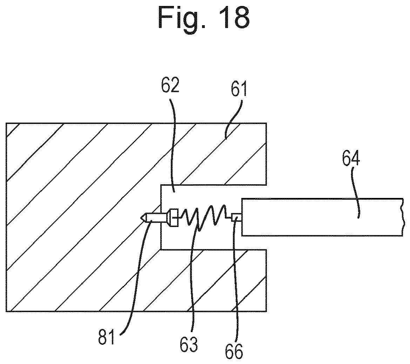

Figure 18 is a schematic diagram of an alternative way of connecting the flexible coupling 63 to the shield 61. As shown in Figure 18, in an embodiment a securing connector (or a fixator) 81 is provided to connect the flexible coupling 63 to the shield 61. In an embodiment the securing connector 81 is configured to be inserted for example compressively secured to the shield for example pushed or screwed into the shield 61 so as to form an electrical connection between the shield 61 and the flexible coupling 63. The flexible coupling 63 may be attached to the end of the connector 81 that is not inserted, for example pushed, into the shield 61. In an embodiment the shield 61 is provided with a recess for accommodating the connector 81 to be pushed into it.

In an alternative embodiment, the orientation of the flexible coupling 63 and the connector 81 may be reversed. In particular, in an embodiment the connector 81 is located between the flexible coupling 63 and the conductor 66 of the electrical cable 64. For example, the connector 81 may be fixed relative to the conductor 66, for example by using a conductive bonding material such as a conductive adhesive or a weld. One end of the flexible coupling 63 is connected to the connector 81. The other end of the flexible coupling 63 may be connected directly to the shield 61.

In an alternative embodiment, the flexible coupling 63 is connected to the shield 61 via a landing pad, similar to the landing pad 76 shown in Figure 12. Possible features of the landing pad are described elsewhere in this document. The landing pad may be provided at the end surface of the recess forming the field free region 62. The flexible coupling 63 may be a fixator and may be pushed against the landing pad by a resilient member, such as a spring. The other end of the flexible coupling 63 may be attached to the conductor 66 of the electrical cable 64 as described above. In a further alternative embodiment, the landing pad may be located at the end of the electrical cable 64. A resilient member such as a spring may be provided so as to generate a small pushing force to keep the flexible coupling 63 in contact with the landing pad at the end of the electrical cable 64. The other end of the flexible coupling 63 may be connected directly to the shield 61.

In an alternative embodiment, the flexible coupling 63 may be connected to the shield 61 by a fixator such as a push clamp. The shield 61 may comprise a recess into which one end of the flexible coupling 63 extends. A push clamp may be provided through another recess in the clamp 61 for holding the end of the flexible coupling 63 relative to the shield 61. In an embodiment the end of the flexible coupling 63 may extend through the push clamp so as to prevent the push clamp from pushing itself out from the shield 61. The push clamp ensures that contact is maintained between the flexible coupling 63 and the shield 61.

The detector may form part of an election-optical device, such as the electron-optical device 40 of any of Figures 1 to 5. The electron-optical device may be configured to generate beamlets from a source beam and to project the beamlets towards a sample. The detector may be disposed facing the sample and be configured to detect electrons emitted from the sample. The detector may comprise an array of current detectors. Signal communication to the detector array may comprise signal communication via optic fiber which may be comprised in the objective lens assembly. An electron-optical apparatus may comprise the electron-optical device. The electron-optical device may comprise a source configured to emit an electron beam. Alternatively the source may be part of the electron-optical apparatus and not part of the electron-optical device. An electron-optical device may comprise one or more electron-optical assemblies.

A plurality of electron-optical devices may be comprised in an electron-optical device array. The electron-optical devices of the electron-optical device array are preferably be configured to focus respective multi-beams simultaneously onto different regions of the same sample.

While the present invention has been described in connection with various embodiments, other embodiments of the invention will be apparent to those skilled in the art from consideration of the specification and practice of the invention disclosed herein. For example, as described above in an embodiment the electron-optical assembly 700 comprises the electrical connector 60. However, an electrical connector 60 of the invention can be used anywhere in the electron-optical device 40 where a problem of possible electrical breakdown may exist. In an embodiment the electron-optical device 40 comprises the electrical connector 60 separately from the electron-optical assembly 700. For example the electrical connector 60 may be located where a low force electrical connection with other parts of the electron-optical device 40 such as the body or frame of the electron-optical device 40 is desirable. The electrical connector 60 may be located where the electrical connection is not required to be particularly low force. The electrical connector 60 may make the electron-optical device 40 more compact while providing a field free region. It is intended that the specification and examples be considered as exemplary only, with a true scope and spirit of the invention being indicated by the following claims.

The descriptions above are intended to be illustrative, not limiting. Thus, it will be apparent to one skilled in the art that modifications may be made as described without departing from the scope of the claims and clauses set out below.

There are provided the following clauses:
Clause 1. A charged particle-optical device for projecting a plurality of charged particle beams along respective beam paths towards a sample location, the charged particle-optical device comprising: a charged particle-optical assembly configured to manipulate the charged particle beams, the charged particle-optical assembly comprising a first charged particle-optical element comprising a plate having one or more apertures around a beam path of the charged particle beams; and an electrical connector configured to electrically connect the plate of the charged particle-optical element to an electrical power source, wherein the electrical connector: comprises a shield configured to define a field free region substantially free of electric fields; and is configured to be electrically connectable via a flexible coupling configured to electrically connect the plate of the charged particle-optical element to the electrical power source, the flexible coupling located within the field free region.
Clause 2. The charged particle-optical device of clause 1, wherein at least part of the shield overlaps the plate of the charged particle-optical element when viewed in a direction perpendicular to a plane of the plate of the charged particle-optical element.
Clause 3. The charged particle-optical device of clause 2, wherein the part of the shield that overlaps the plate of the charged particle-optical element is at only one of an up-beam side and a down-beam side of the plate.
Clause 4. The charged particle-optical device of any preceding clause, wherein the plate of the charged particle-optical element is configured to be electrically connectable to the flexible coupling via the shield.
Clause 5. The charged particle-optical device of any preceding clause, wherein the shield is mechanically fixed relative to the plate of the charged particle-optical element by a mechanical connection.
Clause 6. The charged particle-optical device of clause 5, wherein the shield and the plate are electrically connected via the mechanical connection.
Clause 7. The charged particle-optical device of any preceding clause, wherein the charged particle-optical assembly comprises at least one isolator adjacent to the plate.
Clause 8. The charged particle-optical device of clause 7, wherein the isolator is substantially planar.
Clause 9. The charged particle-optical device of clause 7 or 8, wherein the isolator is substantially parallel to the plate.
Clause 10. The charged particle-optical device of any of clauses 7-9, wherein the plate comprises a protrusion that protrudes beyond a radially outward periphery of the isolator with respect the beam paths.
Clause 11. The charged particle-optical device of clause 10, wherein at least a radially inward portion with respect to the beam paths within the outward periphery of the isolator, is electrically connectable to the flexible coupling via the protrusion.
Clause 12. The charged particle-optical device of any preceding clause, wherein the flexible coupling comprises a wire, the wire extending in an elongate direction.
Clause 13. The charged particle-optical device of any preceding clause, wherein the flexible coupling comprises a resilient element.
Clause 14. The charged particle-optical device of clause 13, wherein the resilient element is resilient in a degree of freedom.
Clause 15. The charged particle-optical device of clause 14, wherein the flexible coupling has an elongate direction and the resilient element is resilient in a degree of freedom corresponding to the elongate direction of the flexible coupling.
Clause 16. The charged particle-optical device of any of clauses 13-15, wherein the resilient element is a pogo pin.
Clause 17. The charged particle device of any preceding clause, wherein the flexible coupling is configured to be positionable with respect to the shield in at least five degrees of freedom.
Clause 18. The charged particle-optical device of any preceding clause, wherein the shield is arranged to surround the flexible coupling when viewed in at least one direction.
Clause 19. The charged particle-optical device of clause 18, wherein the shield defines a recess configured to receive the flexible coupling.
Clause 20. The charged particle-optical device of clause 19, wherein the recess has a substantially circular cross-section.
Clause 21. The charged particle-optical device of clause 20, wherein the substantially circular cross-section is orthogonal to the depth of the recess.
Clause 22. The charged particle-optical device of any of clauses 19-21, wherein the recess is configured to have a surface concentric with an elongate direction of the flexible coupling.
Clause 23. The charged particle-optical device of any preceding clause, wherein the shield comprises a conductive body, desirably in which is defined a recess, desirably the body being configured to connect electrically via the flexible coupling.
Clause 24. The charged particle-optical device of any of clauses 1-17, wherein the shield comprises two planar members defining the field free region between them, desirably wherein the shield is isolated from the flexible coupling, desirably connected to a different power source from the flexible coupling.
Clause 25. The charged particle-optical device of any preceding clause, wherein the shield is arranged such that the field free region has a greater dimension in a direction parallel to a plane of the plate than in a direction perpendicular to the plane of the plate.
Clause 26. The charged particle-optical device of any preceding clause, wherein the shield is arranged such that the field free region is situated adjacent a surface of the plate in a plane across the beam paths.
Clause 27. The charged particle-optical device of any preceding clause, wherein the electrical connector comprises an electrical cable configured to electrically connect the flexible coupling to the electrical power source, wherein the flexible coupling is more flexible than the electrical cable in at least one degree of freedom.
Clause 28. The charged particle-optical device of any preceding clause, wherein the plate has an array of apertures.
Clause 29. The charged particle-optical device of clause 28, wherein the apertures of the array are for the beam paths of respective charged particle beams.
Clause 30. The charged particle-optical device of any preceding clause, the charged particle plate being a first charged particle plate, wherein the charged particle-optical assembly comprises a second charged particle-optical element comprising a plate having one or more apertures around a beam path of the charged particle beams.
Clause 31. The charged particle-optical device of clause 30, comprising another electrical connector configured to electrically connect the plate of the second charged particle-optical element to an electrical power source.
Clause 32. The charged particle-optical device of clause 31, wherein the electrical connectors are arranged such that the shields define respective field free regions that overlap each other in direction along the beam paths.
Clause 33. The charged particle-optical device of any preceding clause, wherein the electrical connector comprises the flexible coupling.
Clause 34. The charged particle-optical device of any preceding clause, wherein the electrical connector comprises a fixator configured to connect to the flexible coupling.
Clause 35. The charged particle-optical device of any preceding clause, wherein the charged particle-optical assembly comprises one or more charged particle-optical elements which comprise a microelectromechanical component.
Clause 36. The charged particle-optical device of any preceding clause, wherein the charged particle-optical assembly is a charged particle-optical lens assembly.
Clause 37. The charged particle-optical device of clause 36, wherein the charged particle-optical lens assembly comprises an objective lens assembly.
Clause 38. The charged particle-optical device of clause 36, wherein the charged particle-optical lens assembly is an objective lens assembly.
Clause 39. The charged particle-optical device of any of clause 36, wherein the charged particle-optical lens assembly comprises a charged particle-optical condenser lens assembly.
Clause 40. The charged particle-optical device of any proceeding clause wherein the charged particle-optical assembly comprises a collimator.
Clause 41. A charged particle-optical assembly for operating on one or more charged particle beams in a charged particle apparatus, along a beam path towards a sample location, the charged particle-optical assembly comprising: a charged particle-optical element comprising a plate having one more apertures around a beam path of one or more charged particle beams and configured to manipulate the one or more charged particle beams; and at least one isolator adjacent the plate around the beam path and configured to mechanically support the plate and electrically isolate the plate; and an electrical connector configured to electrically connect the plate to an electrical power source, wherein the electrical connector comprises a protrusion of the plate that extends radially outward of an outward periphery of the isolator or one of the isolators with respect to the beam path, the protrusion configured to be connectable to the electrical power source via a flexible coupling in a field free region substantially free of electric fields.
Clause 42. The charged particle-optical assembly of clause 41, wherein the electrical connector comprises a shield configured to define the field free region.
Clause 43. The charged particle-optical assembly of clause 41 or 42, wherein the electrical connector comprises a fixator configured to connect to the flexible coupling to electrically connect the plate to the electrical power source.
Clause 44. The charged particle-optical assembly of clause 43, wherein the connector is located in the field free region, during operation of a charged particle apparatus comprising the charged particle-optical assembly.
Clause 45. The charged particle-optical assembly of clause 41 or 42, wherein the electrical connector comprises the flexible coupling located within the field free region.
Clause 46. A charged particle-optical assembly configured to direct a plurality of beams of charged particles in a beam grid towards a sample, the assembly comprising a charged particle-optical component that comprises: a planar charged particle-optical element configured to operate at high voltage on charged particle beams of a beam grid, the element comprising a plurality of apertures for the paths of different beams of the beam grid; an isolating spacer configured to: support and electrically isolate the charged particle-optical element, and be positioned away from the paths of the beams; and a conductive body structurally connected to a connection surface of the assembly and electrically connected to the charged particle element, wherein a recess is defined within the conductive body and is configured to provide a field free volume for insertion of an electrical coupling to electrically connect the charged particle-optical element via the electrical coupling with the conducting body.
Clause 47. The charged particle-optical assembly of clause 46, wherein the connection surface comprises a surface of the isolating spacer.
Clause 48. The charged particle-optical assembly of clause 46, wherein the connection surface comprises a surface of the charged particle-optical element.
Clause 49. The charged particle-optical assembly of clause 46, wherein the connection surface is part of a protrusion desirably comprising a part of the spacer.
Clause 50. The charged particle-optical assembly of any of clauses 46-49, wherein a part of the connection surface extends outward from a periphery of the assembly relative to the paths of the beam grid.
Clause 51. A charged particle-optical apparatus comprising: the charged particle-optical device of any of clauses 1-40 or the charged particle-optical assembly of any of clauses 41-50; and an actuatable stage configured to support a sample.
Clause 52. A method for providing an electrical connection, the method comprising:
   providing a charged particle-optical device configured to project a plurality of charged particle beams along respective beam paths towards a sample location, the charged particle-optical device comprising a charged particle-optical assembly configured to manipulate the charged particle beams, the charged particle-optical assembly comprising a charged particle-optical element comprising a plate having one or more apertures around a beam path of the charged particle beams; and providing an electrical connector configured to electrically connect the plate to an electrical power source, wherein the electrical connector: comprises a shield configured to define a field free region substantially free of electric fields; and is configured to be electrically connectable to a flexible coupling configured to electrically connect the plate to the electrical power source, the flexible coupling located within the field free region.
Clause 53. The method of clause 52, the method comprising: disconnecting the flexible coupling from the electrical power source with the flexible coupling remaining connected to the charged particle-optical lens assembly.
Clause 54. The method of clause 53, the method comprising: replacing the flexible coupling and the charged particle-optical lens assembly with a replacement flexible coupling and a replacement charged particle-optical lens assembly.
Clause 55. The method of clause 54, the method comprising: connecting the replacement flexible coupling to the electrical power source such that the replacement charged particle-optical lens assembly is electrically connected to the electrical power source via the replacement flexible coupling.
Clause 56. The method of any of clauses 52-55, the method comprising: disconnecting the charged particle-optical assembly from the charged particle-optical device.
Clause 57. The method of clause 56, the method comprising: replacing the charged particle-optical assembly with a replacement charged particle-optical assembly.
Clause 58. A method of disconnecting a charged particle-optical assembly from a charged particle-optical device configured to project a plurality of charged particle beams along respective beam paths towards a sample location, the charged particle-optical device comprising a charged particle-optical assembly configured to manipulate the charged particle beams, the charged particle-optical assembly comprising a charged particle-optical element comprising a plate having one or more apertures around a beam path of the charged particle beams, the plate being electrically connected to an electrical power source via a flexible coupling located within a field free region defined by a shield, the method comprising: electrically disconnecting the plate from an electrical power source by disconnecting the flexible coupling from one of the electrical power source and the charged particle-optical assembly with the flexible coupling remaining connected to the other of the charged particle-optical assembly and the electrical power source.
Clause 59. The method of clause 58, the method comprising: disconnecting the charged particle-optical assembly from the charged particle-optical device.
Clause 60. The method of clause 59, the method comprising: replacing the charged particle-optical assembly with a replacement charged particle-optical assembly.

## Claims

1. A charged particle-optical device for projecting a plurality of charged particle beams along respective beam paths towards a sample location, the charged particle-optical device comprising:
a charged particle-optical assembly configured to manipulate the charged particle beams, the charged particle-optical assembly comprising a first charged particle-optical element comprising a plate having one or more apertures around a beam path of the charged particle beams; and
an electrical connector configured to electrically connect the plate of the charged particle-optical element to an electrical power source, wherein the electrical connector:
comprises a shield configured to define a field free region substantially free of electric fields; and
is configured to be electrically connectable via a flexible coupling configured to electrically connect the plate of the charged particle-optical element to the electrical power source, the flexible coupling located within the field free region.

2. The charged particle-optical device of claim 1, wherein at least part of the shield overlaps the plate of the charged particle-optical element when viewed in a direction perpendicular to a plane of the plate of the charged particle-optical element.

3. The charged particle-optical device of claim 2, wherein the part of the shield that overlaps the plate of the charged particle-optical element is at only one of an up-beam side and a down-beam side of the plate.

4. The charged particle-optical device of any preceding claim, wherein the plate of the charged particle-optical element is configured to be electrically connectable to the flexible coupling via the shield.

5. The charged particle-optical device of any preceding claim, wherein the shield is mechanically fixed relative to the plate of the charged particle-optical element by a mechanical connection.

6. The charged particle-optical device of claim 5, wherein the shield and the plate are electrically connected via the mechanical connection.

7. The charged particle-optical device of any preceding claim, wherein the charged particle-optical assembly comprises at least one isolator adjacent to the plate.

8. The charged particle-optical device of claim 7, wherein the isolator is substantially planar.

9. The charged particle-optical device of claim 7 or 8, wherein the isolator is substantially parallel to the plate.

10. The charged particle-optical device of any of claims 7-9, wherein the plate comprises a protrusion that protrudes beyond a radially outward periphery of the isolator with respect the beam paths.

11. The charged particle-optical device of any preceding claim, wherein the flexible coupling comprises a resilient element which is resilient in a degree of freedom.

12. The charged particle-optical device of claim 11, wherein the flexible coupling has an elongate direction and the resilient element is resilient in a degree of freedom corresponding to the elongate direction of the flexible coupling.

13. The charged particle device of any preceding claim, wherein the flexible coupling is configured to be positionable with respect to the shield in at least five degrees of freedom.

14. The charged particle-optical device of any preceding claim, wherein the shield is arranged to surround the flexible coupling when viewed in at least one direction.

15. The charged particle-optical device of claim 14, wherein the shield defines a recess configured to receive the flexible coupling.
